# EUROPEAN PATENT APPLICATION

(11) **EP 4 648 593 A1**
(43) Date of publication of application: **12.11.2025**
(21) Application number: 25171947.2
(22) Date of filing: 23.04.2025
(51) Int. Cl.: H10K 59/80, H10K 50/858, H10K 50/844

(54) **DISPLAY DEVICE**

(30) Priority: 09.05.2024 KR 20240061352
(71) Applicant: Samsung Display Co., Ltd., Yongin-si, Gyeonggi-do 17113 (KR)
(72) Inventor: KIM, Dal Ho, 17113 Giheung-gu, Yongin-si, Gyeonggi-do (KR); KIM, Ji Young, 17113 Giheung-gu, Yongin-si, Gyeonggi-do (KR); KIM, Ji Hye, 17113 Giheung-gu, Yongin-si, Gyeonggi-do (KR); PARK, Eun Ji, 17113 Giheung-gu, Yongin-si, Gyeonggi-do (KR); SUNG, Hyang Ki, 17113 Giheung-gu, Yongin-si, Gyeonggi-do (KR); JEONG, Hee Seong, 17113 Giheung-gu, Yongin-si, Gyeonggi-do (KR); HAN, Jong Seok, 17113 Giheung-gu, Yongin-si, Gyeonggi-do (KR)
(74) Representative: Dr. Weitzel & Partner

(57) **Abstract**

A display device according to one or more embodiments of the present invention includes: a substrate (100); a light-emitting element (ED) on the substrate; a multi-capping layer (300) comprising a first capping layer (310) on the light-emitting element and having a first refractive index, and a second capping layer (320) on the first capping layer and having a second refractive index lower than the first refractive index; a low refractive layer (400) on the multi-capping layer, and having a third refractive index lower than the second refractive index; and a first encapsulation layer (510) on the low refractive layer, and comprising inorganic encapsulation layers having a refractive index higher than the third refractive index.

## Description

The present invention relates to a display device and an electronic device including the same.

With the advance of information-oriented society, more and more demands are placed on display devices for displaying images in various ways. Along with this trend, various types of display devices including a light-emitting display device are being developed. A light-emitting display device includes a pixel including a light-emitting element.

The above information disclosed in this Background section is only for enhancement of understanding of the background of the invention and therefore it may contain information that does not form the prior art.

### SUMMARY

The present invention provides a display device capable of improving the optical characteristics of a pixel. The present invention also provides an electronic device including the display device for providing an image.

However, aspects of the present invention are not restricted to the one set forth herein. The above and other aspects of the present invention will become more apparent to one of ordinary skill in the art to which the present invention pertains by referencing the detailed description of the present invention given below.

According to some embodiments of the invention, there is provided a display device including: a substrate; a light-emitting element on the substrate; a multi-capping layer including a first capping layer on the light-emitting element and having a first refractive index, and a second capping layer on the first capping layer and having a second refractive index lower than the first refractive index; a low refractive layer on the multi-capping layer, and having a third refractive index lower than the second refractive index; and a first encapsulation layer on the low refractive layer, and including inorganic encapsulation layers having a refractive index higher than the third refractive index.

In some embodiments, the first refractive index may have a value in a range of about 1.2 to about 3.0, and the second refractive index may have a value in a range of about 1.0 to about 2.8.

In some embodiments, a difference between the first refractive index and the second refractive index is about 02 or more.

In some embodiments, a difference between the second refractive index and the third refractive index may be about 0.2 or more.

In some embodiments, the first capping layer may have a thickness ranging from about 20 nm (200 Å) to about 140 nm (1400 Å).

In some embodiments, the second capping layer may have a thickness ranging from about 5 nm (50 Å) to about 100 nm (1000 Å).

In some embodiments, the low refractive layer may have a thickness ranging from about 20 nm (200 Å) to about 100 nm (1000 Å).

In some embodiments, the first encapsulation layer may include: a first inorganic encapsulation layer on the low refractive layer, having a fourth refractive index higher than the third refractive index; a second inorganic encapsulation layer on the first inorganic encapsulation layer, having a fifth refractive index lower than the fourth refractive index; and a third inorganic encapsulation layer on the second inorganic encapsulation layer, having a sixth refractive index lower than the fifth refractive index.

In some embodiments, the first inorganic encapsulation layer may include silicon nitride (SiNₓ).

In some embodiments, the second inorganic encapsulation layer and the third inorganic encapsulation layer may include silicon oxynitride (SiON), and a content of nitrogen contained in the second inorganic encapsulation layer and a content of nitrogen contained in the third inorganic encapsulation layer may be different from each other.

In some embodiments, the display device may further include: a second encapsulation layer on the first encapsulation layer and containing an organic material; and a third encapsulation layer on the second encapsulation layer and containing an inorganic material.

In some embodiments, the display device may further include: a fourth encapsulation layer between the first encapsulation layer and the second encapsulation layer, the fourth encapsulation layer comprises silicon oxynitride (SiON), and a content of oxygen contained in the fourth encapsulation layer may be higher than a content of oxygen contained in the first encapsulation layer.

In some embodiments, the light-emitting element may include: a first electrode on the substrate; an intermediate layer on the first electrode and including a light-emitting layer; and a second electrode on the intermediate layer.

In some embodiments, the first capping layer may be directly on the second electrode, and the second capping layer may be directly on the first capping layer.

In some embodiments, the low refractive layer may be directly on the second capping layer.

In some embodiments, the multi-capping layer may further include a third capping layer between the second electrode and the first capping layer and having a refractive index lower than the first refractive index.

In some embodiments, the refractive index of the third capping layer may have a value in a range of about 1.0 to about 2.8.

In some embodiments, a difference between the refractive index of the third capping layer and the first refractive index may be about 0.2 or more.

In some embodiments, the third capping layer may have a thickness ranging from about 5 nm (50 Å) to about 100 nm (1000 Å).

In some embodiments, the multi-capping layer may further include at least one of: a fourth capping layer between the first capping layer and the second capping layer, and having a refractive index that gradually decreases as it approaches the second capping layer in a range greater than or equal to the second refractive index and less than or equal to the first refractive index; or a fifth capping layer between the third capping layer and the first capping layer, and having a refractive index that gradually increases as it approaches the first capping layer in a range greater than or equal to the refractive index of the third capping layer and less than or equal to the first refractive index.

According to some embodiments of the invention, there is provided a display device including: a substrate; a light-emitting element on the substrate; a multi-capping layer including a first capping layer on the light-emitting element and having a first refractive index, and a second capping layer on the first capping layer and having a second refractive index different from the first refractive index; a low refractive layer on the multi-capping layer, and having a third refractive index lower than the first refractive index and the second refractive index; and a first encapsulation layer on the low refractive layer, and including an inorganic encapsulation layer having a refractive index higher than the third refractive index.

In some embodiments, a difference between the first refractive index and the second refractive index may be about 0.2 or more.

In some embodiments, a difference between the second refractive index and the third refractive index may be about 0.2 or more.

In some embodiments, the first encapsulation layer may include: a first inorganic encapsulation layer on the low refractive layer, and having a fourth refractive index higher than the third refractive index; a second inorganic encapsulation layer on the first inorganic encapsulation layer, and having a fifth refractive index lower than the fourth refractive index; and a third inorganic encapsulation layer on the second inorganic encapsulation layer, and having a sixth refractive index lower than the fifth refractive index.

In some embodiments, the display device may further include: a second encapsulation layer on the first encapsulation layer and containing an organic material; and a third encapsulation layer on the second encapsulation layer and containing an inorganic material.

According to some embodiments of the invention, there is provided an electronic device for providing an image, including a display device, the display device including: a substrate; a light-emitting element on the substrate; a multi-capping layer including a first capping layer on the light-emitting element and having a first refractive index, and a second capping layer on the first capping layer and having a second refractive index lower than the first refractive index; a low refractive layer on the multi-capping layer, and having a third refractive index lower than the second refractive index; and a first encapsulation layer on the low refractive layer, and including inorganic encapsulation layers having a refractive index higher than the third refractive index.

However, effects according to the embodiments of the present invention are not limited to those exemplified above and various other effects are incorporated herein.

### BRIEF DESCRIPTION OF THE DRAWINGS

The above and other aspects and features of the present invention will become more apparent by describing in detail embodiments thereof with reference to the attached drawings, in which:
FIG. 1 is a plan view schematically illustrating a display device according to some embodiments of the present invention;
FIG. 2 is an equivalent circuit diagram illustrating a pixel according to some embodiments of the present invention;
FIG. 3 is a cross-sectional view illustrating a display device according to some embodiments of the present invention;
FIG. 4 is a cross-sectional view illustrating a display device according to some embodiments of the present invention;
FIG. 5 is a schematic diagram schematically showing a display device according to some embodiments of the present invention;
FIG. 6 is a schematic diagram schematically showing a display device according to some embodiments of the present invention;
FIG. 7 is a diagram illustrating an MPCD of a display device according to some embodiments of FIGS. 5 and 6;
FIG. 8 is a schematic diagram schematically showing a display device according to some embodiments of the present invention;
FIG. 9 is a schematic diagram schematically showing a display device according to some embodiments of the present invention; and
FIG. 10 is a schematic diagram schematically showing a display device according to some embodiments of the present invention.

### DETAILED DESCRIPTION

Hereinafter, embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present invention.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present invention. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present invention refers to "one or more embodiments of the present invention." As used herein, the terms "use," "using," and "used" may be considered synonymous with the terms "utilize," "utilizing," and "utilized," respectively.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the example embodiments of the present invention.

[0011] Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Features of each of various embodiments of the present invention may be partially or entirely combined with each other and may technically variously interwork with each other, and respective embodiments may be implemented independently of each other or may be implemented together in association with each other.

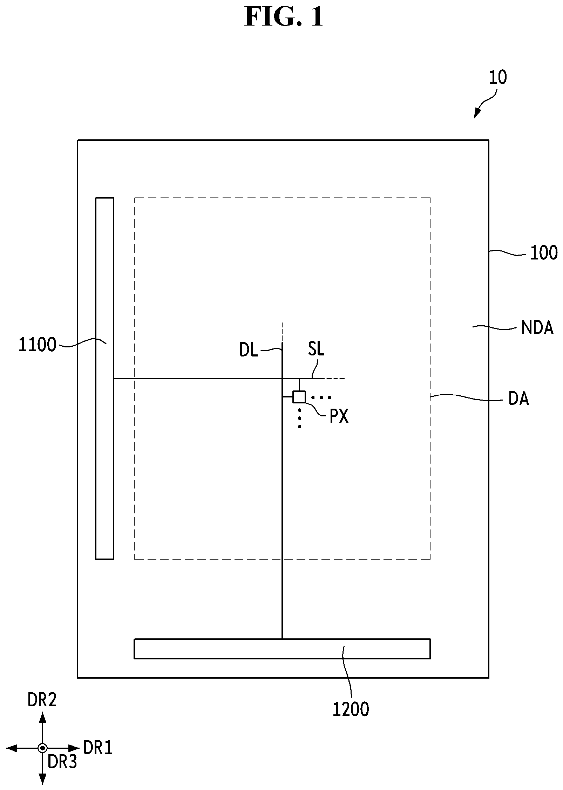

FIG. 1 is a plan view schematically illustrating a display device according to some embodiments of the present invention.

Referring to FIG. 1, a display device 10 according to some embodiments may include a substrate 100 and pixels PX disposed (e.g., positioned or located) on the substrate 100. The display device 10 may further include a scan driver 1100 and a data driver 1200 electrically connected to the pixels PX. The scan driver 1100 and the data driver 1200 may be disposed on the substrate 100, but are not limited thereto. For example, at least one of the scan driver 1100 or the data driver 1200 may be disposed on a circuit board (e.g., a flexible printed circuit board (FPCB)) electrically connected to pads disposed on the substrate 100.

The substrate 100 may be a base layer for manufacturing or providing the display device 10, and may form a support for a display panel including the pixels PX. The substrate 100 may include a display area DA and a non-display area NDA around the display area DA. The display area DA may be an area in which the pixels PX are disposed, and may be an area in which an image is displayed by the pixels PX. The non-display area NDA may be an area other than the display area DA, and may be disposed around the display area DA. For example, the non-display area NDA may surround the display area DA.

A first direction DR1, a second direction DR2, and a third direction DR3 are defined in FIG. 1. In some embodiments, the first direction DR1 may be a horizontal direction of the display device 10 (or substrate 100), and the second direction DR2 may be a vertical direction of the display device 10. The third direction DR3 may be a thickness direction of the display device 10.

In FIG. 1, the substrate 100 and the display area DA are shown as having a quadrilateral shape in a plan view, but the embodiments are not limited thereto. For example, the shapes of the substrate 100 and the display area DA may be variously changed as desired. In addition, in FIG. 1, the corner portions of the substrate 100 and the display area DA are shown in an angled shape, but the embodiments are not limited thereto. For example, the substrate 100 and the display area DA may include corner portions having an angled or rounded shape.

The pixels PX and wires (or some of the wires) connected to the pixels PX may be disposed in the display area DA. For example, the pixels PX, scan lines SL, and data lines DL may be disposed in the display area DA. In describing embodiments, the term "connect" may include electrical connection and/or physical connection. FIG. 1 illustrates only one pixel PX, and one scan line SL, and one data line DL connected to the pixel PX, but the plurality of pixels PX, the plurality of scan lines SL, and the plurality of data lines DL connected to the plurality of pixels PX may be disposed in the display area DA.

The pixel PX may be further connected to an additional wire. For example, the pixel PX may be further connected to a first power line through which a first power voltage is applied and a second power line through which a second power voltage is applied. The type or number of wires connected to the pixel PX may be variously changed in a suitable manner depending on the configuration (e.g., a structure, an operation method, or the like of a pixel circuit) of the pixel PX.

Wires (e.g., a portion of wires extending from the display area DA to the non-display area NDA) connected to the pixels PX may be disposed in the non-display area DA. In some embodiments, the scan driver 1100 and the data driver 1200 may be disposed in the non-display area DA.

The scan driver 1100 may be connected to the pixels PX through the scan lines SL. The scan driver 1100 may supply scan signals to the pixels PX. In some embodiments, the scan driver 1100 may be formed on the substrate 100 together with the pixels PX, but the present invention is not limited thereto.

Although FIG. 1 illustrates some embodiments in which the scan driver 1100 is disposed to only one side (e.g., left side) of the display area DA, the embodiments are not limited thereto. For example, the scan driver 1100 may be disposed to both sides (e.g., left and right sides) of the display area DA. In some examples, the scan driver 1100 may be disposed on the circuit board that is electrically connected to the pixels PX through the pads disposed on the substrate 100.

The data driver 1200 may be connected to the pixels PX through the data lines DL. The data driver 1200 may supply data signals. In some embodiments, the data driver 1200 may be formed as an integrated circuit (IC) chip and may be disposed or mounted on the substrate 100, but is not limited thereto. For example, the data driver 1200 may be disposed on the circuit board that is electrically connected to the pixels PX through the pads disposed on the substrate 100.

In some embodiments, the display device 10 may be a light-emitting display device, such as an organic light-emitting display, including an organic light-emitting diode, a quantum dot light-emitting display including a quantum dot light-emitting layer, an inorganic light-emitting display including an inorganic semiconductor, an ultra-small light-emitting display including an ultra-small light-emitting diode, such as a micro or nano light-emitting diode (micro LED or nano LED), or the like, but is not limited thereto. For example, the display device 10 may be another type of display device other than a light-emitting display device. In the following, embodiments in which the display device 10 is an organic light-emitting display device will be disclosed. However, the display device 10 according to some embodiments is not limited to an organic light-emitting display device, and the technical aspects of embodiments to be described later may be applied to other types of display devices.

The display device 10 may further include additional components. For example, the display device 10 may further include a timing controller electrically connected to the scan driver 1100 and the data driver 1200, and a power supply circuit electrically connected to the pixels PX, the scan driver 1100, and the data driver 1200.

In some embodiments, the display device 10 may be included in or provided with an electronic device. For example, the display device 10 may be included in or provided with one of various types of electronic devices for providing an image.

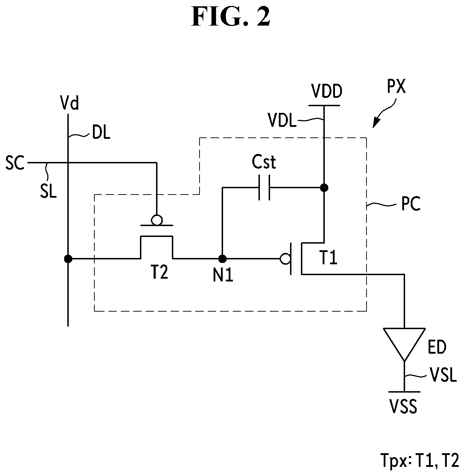

FIG. 2 is an equivalent circuit diagram illustrating a pixel according to some embodiments of the present invention. The pixel PX of FIG. 2 is merely disclosed as one example, and the structure or type of the pixel PX may be changed in various suitable ways according to some embodiments.

Referring to FIG. 2, the pixel PX may include a light-emitting element ED, and a pixel circuit PC connected to the light-emitting element ED. The light-emitting element ED is a light source of the pixel PX, and it may be, for example, an organic light-emitting diode. The pixel circuit PC may supply a driving current corresponding to a data signal Vd to the light-emitting element ED.

The pixel circuit PC may be connected to driving lines through which driving signals for driving the pixel PX are applied, and power lines through which power voltages for driving the pixel PX are applied. For example, the pixel circuit PC may be connected to the scan line SL through which a scan signal SC is applied, the data line DL through which the data signal Vd is applied, a first power line VDL through which a first power voltage VDD (e.g., a high potential pixel voltage) is applied, and a second power line VSL through which a second power voltage VSS (e.g., a low potential pixel voltage) is applied.

The pixel circuit PC may include pixel transistors Tpx and a capacitor Cst. For example, the pixel circuit PC may include a first transistor T1, a second transistor T2, and the capacitor Cst.

The structure of the pixel circuit PC or the type and number of the circuit elements constituting the pixel circuit PC may be variously changed in a suitable manner, as desired. For example, the pixel circuit PC may further include at least one other pixel transistor and/or at least one other capacitor. In addition, although FIG. 2 illustrates some embodiments in which the pixel transistors Tpx are all p-type transistors, the embodiments are not limited thereto. For example, at least one pixel transistor Tpx may be formed as an n-type transistor.

The pixel circuit PC may supply a driving current to the light-emitting element ED in response to the driving signals supplied from the scan driver 1100 and the data driver 1200. For example, the pixel circuit PC may supply a driving current to the light-emitting element ED in response to the scan signal SC supplied from the scan driver 1100 through the scan line SL and the data signal Vd supplied from the data driver 1200 through the data line DL.

The first transistor T1 may be a driving transistor that controls the driving current of the pixel PX in response to the voltage of a first node N1. The first transistor T1 may include a gate electrode connected to the first node N1, a first electrode connected to the first power line VDL, and a second electrode connected to the light-emitting element ED. The first transistor T1 may control the driving current flowing to the light-emitting element ED to correspond to the data signal Vd transmitted to the first node N1.

The second transistor T2 may be a switching transistor that is turned on in response to the scan signal SC. The second transistor T2 may include a gate electrode connected to the scan line SL, a first electrode connected to the data line DL, and a second electrode connected to the first node N1. The second transistor T2 may be turned on by the scan signal SC of a gate-on voltage transmitted through the scan line SL to connect the data line DL to the first node N1. Accordingly, the data signal Vd applied to the data line DL may be transmitted to the first node N1.

Depending on the type (e.g., p-type or n-type transistor) and/or the operating condition of each of the first transistor T1 and the second transistor T2, the first electrode of each of the first transistor T1 and the second transistor T2 may be a source electrode or a drain electrode, and the second electrode thereof may be an electrode different from the first electrode. For example, when the first electrode of the first transistor T1 is a source electrode, the second electrode of the first transistor T1 may be a drain electrode.

The capacitor Cst may be a storage capacitor of the pixel PX and may store a voltage corresponding to the data signal Vd (e.g., data voltage). The capacitor Cst may be connected between the gate electrode and the first electrode of the first transistor T1. For example, the capacitor Cst may be connected between the first node N1 and the first power line VDL. In another embodiment, the first transistor T1 may be an n-type transistor, and the capacitor Cst may be connected between the gate electrode and the second electrode of the first transistor T1.

The light-emitting element ED may be connected between the pixel circuit PC and the second power line VSL. The light-emitting element ED may include a first electrode (e.g., an anode electrode or a pixel electrode), a second electrode (e.g., a cathode electrode or a counter electrode) opposite to the first electrode, and a light-emitting layer (e.g., an organic light-emitting layer) interposed between the first electrode and the second electrode. The first electrode of the light-emitting element ED may be connected to the pixel circuit PC. The second electrode of the light-emitting element ED may be connected to the second power line VSL. In some embodiments, the second electrode of the light-emitting element ED may be a common electrode shared by the pixels PX. The light-emitting element ED may emit light with a luminance corresponding to the driving current during a time period in which the driving current is supplied from the pixel circuit PC.

The light-emitting element ED may emit light of a specific color. For example, the light-emitting element ED of each pixel PX may emit light in red, green, or blue color, or may emit light in red, green, blue, or white color.

In some embodiments, the pixels PX of the display area DA may include a first pixel that emits light of a first color, a second pixel that emits light of a second color, and a third pixel that emits light of a third color. At least one first pixel, the second pixel, and the third pixel adjacent to each other may form a single unit pixel.

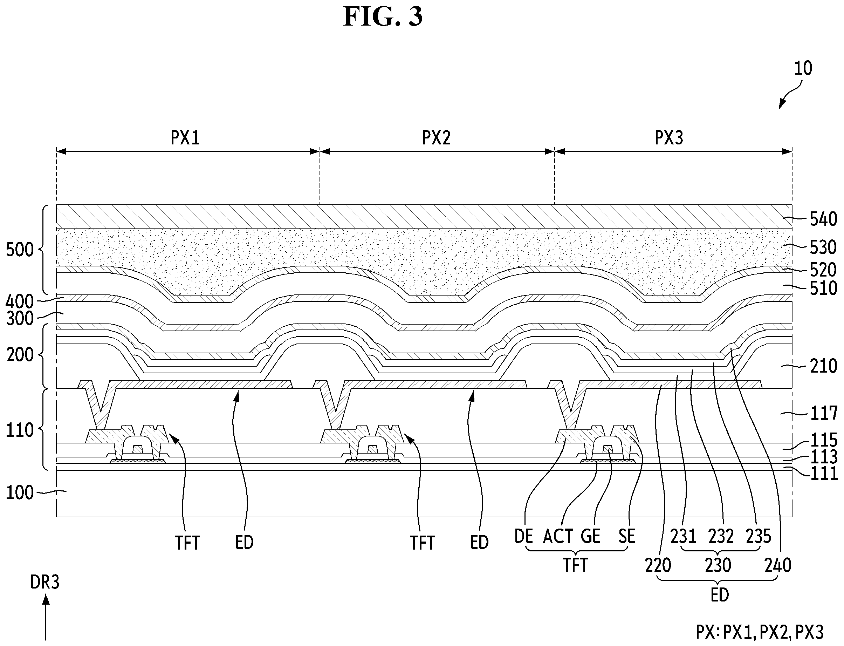

FIG. 3 is a cross-sectional view illustrating a display device according to some embodiments of the present invention. For example, FIG. 3 shows a cross section of a portion of the display device 10 in which a first pixel PX1, a second pixel PX2, and a third pixel PX3 are disposed.

Referring to FIGS. 1 to 3, the display device 10 may include the substrate 100, a pixel circuit layer 110, a light-emitting element layer 200, a capping layer 300, a low refractive layer 400, and an encapsulation layer 500 disposed on the substrate 100. In some embodiments, the pixel circuit layer 110, the light-emitting element layer 200, the capping layer 300, the low refractive layer 400, and the encapsulation layer 500 may be sequentially disposed on the substrate 100 along the third direction DR3.

The substrate 100 may be a lower substrate of the display device 10. The substrate 100 may be formed as a single layer or multiple layers, and may have rigid or flexible characteristics.

In some embodiments, the substrate 100 may be a substrate containing an insulating material, such as glass or the like, and having rigid characteristics, and may not be bent. In some examples, the substrate 100 may be a flexible substrate that contains polyimide or another insulating material and may be transformed to be bent, folded, or rolled, and may or may not be bent. The type, structure, and/or material of the substrate 100 may change depending on embodiments.

The pixel circuit layer 110 (e.g., a thin film transistor layer) may be disposed on the substrate 100. The substrate 100 and the pixel circuit layer 110 may form a backplane layer of the display device 10.

The pixel circuit layer 110 may include wires (e.g., the scan line SL, the data line DL, the first power line VDL, and the second power line VSL in FIG. 2) and circuit elements (e.g., the pixel transistors Tpx and the capacitor Cst in FIG. 2) constituting the pixel circuit PC of each of the pixels PX. In some embodiments, the pixel circuit layer 110 may further include circuit elements of the scan driver 1100. In some embodiments, the pixel transistors Tpx disposed in the pixel circuit layer 110 may be thin film transistors TFT formed by a thin film deposition process or the like.

FIG. 3 shows a single thin film transistor TFT as an example of circuit elements that may be disposed in the pixel circuit layer 110 in each pixel PX. The thin film transistor TFT of FIG. 3 may be one of the pixel transistors Tpx provided in the pixel circuit PC of the corresponding pixel PX. In some embodiments, the thin film transistor TFT of FIG. 3 may be the first transistor T1 of FIG. 2, and may be connected to a first electrode 220 of the light-emitting element ED disposed in each pixel PX.

The pixel circuit layer 110 may further include insulating layers. In some embodiments, the pixel circuit layer 110 may include a buffer layer 111, a gate insulating layer 113, an interlayer insulating layer 115, and a planarization insulating layer 117 sequentially disposed on the substrate 100.

In some embodiments, each of the buffer layer 111, the gate insulating layer 113, and the interlayer insulating layer 115 may contain an inorganic insulating material, and may be formed as a single layer or multiple layers. In some embodiments, each of the buffer layer 111, the gate insulating layer 113, and the interlayer insulating layer 115 may contain silicon oxide (SiOₓ), silicon nitride (SiNₓ), silicon oxynitride (SiON or SiOₓN_{y}), titanium oxide (TiO₂ or TiOₓ), aluminum oxide (Al₂O₃ or AlₓO_{y}), and/or other inorganic insulating materials.

In some embodiments, the planarization insulating layer 117 may contain an organic insulating material, and may be formed as a single layer or multiple layers. In some embodiments, the planarization insulating layer 117 may contain an acryl resin, epoxy resin, phenolic resin, polyamide resin, polyimide resin, benzocyclobutene (BCB), hexamethyldisiloxane (HMDSO), and/or other organic insulating materials. The top surface of the planarization insulating layer 117 may be substantially flat.

The thin film transistor TFT may include an active layer ACT and a gate electrode GE overlapping a part of the active layer ACT. In some embodiments, the gate electrode GE may be disposed on a part of the active layer ACT.

In some embodiments, the thin film transistor TFT may further include a source electrode SE and a drain electrode DE connected to different portions (e.g., a source region and a drain region) of the active layer ACT. In some examples, the thin film transistor TFT may not include (e.g., omit) separate source electrode SE and/or drain electrode DE, and the source region and/or the drain region of the active layer ACT may be connected to another circuit element, a conductive pattern, a wire, or the like, thereby functioning as the source electrode and/or the drain electrode of the thin film transistor TFT.

FIG. 3 illustrates some embodiments in which the drain electrode DE of the thin film transistor TFT is connected to the light-emitting element ED, but the embodiments are not limited thereto. For example, when the thin film transistor TFT is an n-type transistor, the source electrode SE of the thin film transistor TFT may be connected to the light-emitting element ED.

The active layer ACT may be disposed on the buffer layer 111. The active layer ACT may include a channel region overlapping the gate electrode GE and the source and drain regions on both sides of the channel region. The source and drain regions may be regions made conductive by doping or other methods to have a higher conductivity than the channel region. The source region of the active layer ACT may be connected to the source electrode SE, and the drain region of the active layer ACT may be connected to the drain electrode DE.

The active layer ACT may contain a semiconductor material. For example, the active layer ACT may contain polysilicon, amorphous silicon, oxide semiconductor, and/or other semiconductor materials. The active layer ACT may be covered with the gate insulating layer 113.

The gate electrode GE may be disposed on the gate insulating layer 113. The gate electrode GE may be covered with the interlayer insulating layer 115.

The source electrode SE and the drain electrode DE may be disposed on the interlayer insulating layer 115. The source electrode SE and the drain electrode DE may be covered with the planarization insulating layer 117.

Each of the gate electrode GE, the source electrode SE, and the drain electrode DE may contain a conductive material, and may be formed as a single layer or multiple layers. For example, each of the gate electrode GE, the source electrode SE, and the drain electrode DE may contain at least one of copper (Cu), titanium (Ti), molybdenum (Mo), aluminum (Al), chromium (Cr), gold (Au), silver (Ag), platinum (Pt), palladium (Pd), nickel (Ni), neodymium (Nd), iridium (Ir), tantalum (Ta), tungsten (W), magnesium (Mg), or another metal, an alloy thereof, or another conductive material. When the source electrode SE and the drain electrode DE are disposed at the same layer, the source electrode SE and the drain electrode DE may be substantially simultaneously formed using the same conductive material.

The light-emitting element layer 200 may be disposed on the pixel circuit layer 110. The light-emitting element layer 200 may include light-emitting elements ED and a pixel defining film 210. The pixel defining film 210 may define or partition emission areas (e.g., an emission area of each of the pixels PX) in which the light-emitting elements ED are disposed. In some embodiments, the pixel defining film 210 may overlap a portion (e.g., an edge portion) of the light-emitting elements ED.

Each of the light-emitting elements ED may include the first electrode 220, an intermediate layer 230, and a second electrode 240 sequentially disposed on the pixel circuit layer 110.

The first electrode 220 may be disposed in each pixel area where the pixel PX is disposed. The first electrode 220 may be disposed on the planarization insulating layer 117.

In some embodiments, the first electrode 220 may be a reflective electrode. For example, the first electrode 220 may include a reflective film containing silver (Ag), magnesium (Mg), aluminum (Al), platinum (Pt), palladium (Pd), gold (Au), nickel (Ni), neodymium (Nd), iridium (Ir), chromium (Cr) or a compound thereof.

In some embodiments, the first electrode 220 may further include a transparent or translucent electrode layer disposed on top and/or bottom of the reflective film. In some embodiments, the transparent or translucent electrode layer of the first electrode 220 may contain at least one material selected from the group consisting of indium tin oxide (ITO), indium zinc oxide (IZO), zinc oxide (ZnO), indium oxide (InO or In₂O₃), indium gallium oxide (IGO), and aluminum zinc oxide (AZO). For example, the first electrode 220 may be formed as a triple layer with an ITO layer, an Ag layer, and an ITO layer, but is not limited thereto.

The pixel defining film 210 may be disposed between the emission areas of the pixels PX and may include openings corresponding to the emission areas. In some embodiments, a portion of the pixel defining film 210 may cover the edge portion of the emission areas.

In some embodiments, the pixel defining film 210 may cover a part of each of the first electrodes 220. For example, the pixel defining film 210 may cover the edge portion of each of the first electrodes 220 and may be opened to expose the other portion of each of the first electrodes 220.

In some embodiments, the pixel defining film 210 may include at least one organic insulating layer containing an organic insulating material. For example, the pixel defining film 210 may contain an organic insulating material such as polyimide, polyamide, acrylic resin, benzocyclobutene, hexamethyldisiloxane (HMDSO), or phenol resin.

The intermediate layer 230 may be disposed on the first electrode 220 and the pixel defining film 210. The intermediate layer 230 may include a light-emitting layer 232 (or a first light-emitting layer) of each of the light-emitting elements ED. In some embodiments, the intermediate layer 230 may further include at least one of a first functional layer 231 disposed between the first electrode 220 and the light-emitting layer 232, or a second functional layer 235 disposed between the light-emitting layer 232 and the second electrode 240.

The light-emitting layer 232 may be disposed in the emission area of each of the pixels PX. For example, the light-emitting layer 232 may be positioned in the opening of the pixel defining film 210 and may be surrounded by the pixel defining film 210. In some embodiments, the light-emitting layer 232 may be individually disposed in each pixel area corresponding to each pixel PX.

The light-emitting layer 232 may contain a fluorescent or phosphorescent material capable of emitting light of a specific color. In some embodiments, the light-emitting element ED may be an organic light-emitting diode, and the light-emitting layer 232 may contain a low molecular weight organic material or a high molecular weight organic material.

In some embodiments, the light-emitting elements ED of the first pixel PX1, the second pixel PX2, and the third pixel PX3 may emit light of different wavelengths. For example, the light-emitting element ED of the first pixel PX1, the light-emitting element ED of the second pixel PX2, and the light-emitting element ED of the third pixel PX3 may emit light of the first color, light of the second color, and light of the third color, respectively.

In some embodiments, the light-emitting element ED of the first pixel PX1 may be a red organic light-emitting diode, and the light-emitting layer 232 included in the light-emitting element ED of the first pixel PX1 may be a red light-emitting layer that emits red light. The light-emitting element ED of the second pixel PX2 may be a green organic light-emitting diode, and the light-emitting layer 232 included in the light-emitting element ED of the second pixel PX2 may be a green light-emitting layer that emits green light. The light-emitting element ED of the third pixel PX3 may be a blue organic light-emitting diode, and the light-emitting layer 232 included in the light-emitting element ED of the third pixel PX3 may be a blue light-emitting layer that emits blue light.

The first functional layer 231 may include at least one of a hole transport layer (HTL) or a hole injection layer (HIL). In some embodiments, the first functional layer 231 may include a hole transport layer, or may include a hole transport layer and a hole injection layer. In some embodiments, the first functional layer 231 or at least one layer constituting the first functional layer 231 may be a common layer disposed over the entire display area DA.

The second functional layer 235 may include at least one of an electron transport layer (ETL) or an electron injection layer (EIL). In some embodiments, the second functional layer 235 may include an electron transport layer, or may include an electron transport layer and an electron injection layer. In some embodiments, the second functional layer 235 or at least one layer constituting the second functional layer 235 may be a common layer disposed over the entire display area DA.

The second electrode 240 may be disposed on the intermediate layer 230 of each of the light-emitting elements ED. In some embodiments, the second electrode 240 may be a common layer disposed over the entire display area DA.

In some embodiments, the second electrode 240 may be a transparent or translucent electrode, through which light generated in the light-emitting layer 232 of each of the light-emitting elements ED can be transmitted. For example, the second electrode 240 may include a transparent or translucent conductive layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), an alloy thereof, or the like. In some embodiments, the second electrode 240 may include silver (Ag), magnesium (Mg), or an alloy of silver (Ag) and magnesium (Mg), but is not limited thereto. In some embodiments, the second electrode 240 may be formed as multiple layers further including a conductive layer overlapping the transparent conductive layer or the translucent conductive layer and containing transparent conductive oxide (TCO) such as indium tin oxide (ITO), indium zinc oxide (IZO), zinc oxide (ZnO), or indium oxide (InO or In₂O₃), but is not limited thereto.

The capping layer 300 may be disposed on the light-emitting element layer 200. The capping layer 300 may cover and protect the second electrode 240 of the light-emitting elements ED. For example, the capping layer 300 may contain a material with a high barrier effect (e.g., a high level of protection) against moisture or oxygen, and may directly cover the second electrode 240 to prevent or substantially reduce moisture or oxygen from permeating into the light-emitting elements ED. The capping layer 300 may contain an inorganic insulating material or an organic insulating material.

In some embodiments, the capping layer 300 may be formed as multiple films including at least two films sequentially stacked on the second electrode 240. The at least two films may have different refractive indices. Embodiments related to the structure of the capping layer 300 will be described later.

In some embodiments, the low refractive layer 400 may be disposed on the capping layer 300. The low refractive layer 400 may contain a material having a lower refractive index than that of the capping layer 300. In some embodiments, the low refractive layer 400 may have a refractive index lower than that of each film forming the capping layer 300.

Although FIG. 3 shows the capping layer 300 and the low refractive layer 400 as separate elements, the embodiments are not limited thereto. For example, in some other embodiments, the low refractive layer 400 may be considered as an element included in the capping layer 300. In this case, the capping layer 300 may include at least three films including the low refractive layer 400. In still other embodiments, the display device 10 may not include (e.g., omit) the low refractive layer 400, and the encapsulation layer 500 may be disposed directly on the capping layer 300.

The encapsulation layer 500 may be disposed on the capping layer 300 and/or the low refractive layer 400. The encapsulation layer 500 may block the permeation of moisture or oxygen into the light-emitting element layer 200 and the like, and may mitigate electrical and/or physical impacts on the pixel circuit layer 110, the light-emitting element layer 200, and the like.

In some embodiments, the encapsulation layer 500 may include a first encapsulation layer 510, a second encapsulation layer 530, and a third encapsulation layer 540 sequentially disposed on the low refractive layer 400. In some embodiments, the encapsulation layer 500 may further include a fourth encapsulation layer 520 disposed between the first encapsulation layer 510 and the second encapsulation layer 530.

Each of the first encapsulation layer 510 and the third encapsulation layer 540 may be an inorganic encapsulation layer containing an inorganic material. For example, each of the first encapsulation layer 510 and the third encapsulation layer 540 may contain one or more inorganic insulating materials selected from silicon oxide (SiOₓ), silicon nitride (SiNₓ), silicon oxynitride (SiON), titanium oxide (TiO₂ or TiOₓ), aluminum oxide (Al₂O₃ or AlₓO_{y}), hafnium oxide (HfO₂ or HfOₓ), or zinc oxide (ZnO).

In some embodiments, each of the first encapsulation layer 510 and the third encapsulation layer 540 may be an inorganic insulating layer containing a non-metallic element, and may contain, for example, silicon oxide (SiOₓ), silicon nitride (SiNₓ), or silicon oxynitride (SiON). In some embodiments, each of the first encapsulation layer 510 and the third encapsulation layer 540 may be formed by a chemical vapor deposition (CVD) method, but is not limited thereto.

In some embodiments, the number, type, and/or content of non-metallic elements contained in the first encapsulation layer 510 may be different from the number, type, and/or content of non-metallic elements contained in the third encapsulation layer 540. For example, the first encapsulation layer 510 may contain silicon oxynitride (SiON), and the third encapsulation layer 540 may contain silicon nitride (SiNₓ), but are not limited thereto. In some embodiments, when the third encapsulation layer 540 contains silicon nitride (SiNₓ), the third encapsulation layer 540 may have a relatively high refractive index. For example, the refractive index of the third encapsulation layer 540 may be about 1.77 or more, for example, the refractive index of the third encapsulation layer 540 may be approximately 1.8 to approximately 2.3, but is not limited thereto.

In some embodiments, the first encapsulation layer 510 may be formed as multiple inorganic encapsulation layers, including at least two inorganic encapsulation layers sequentially stacked on the low refractive layer 400, and the at least two inorganic encapsulation layers may have different refractive indices. In some embodiments, the inorganic encapsulation layers may have a refractive index higher than that of the low refractive layer 400. A detailed description of the structure of the first encapsulation layer 510 will be provided later.

The second encapsulation layer 530 may be an organic encapsulation layer containing an organic material. The second encapsulation layer 530 may mitigate the internal stress of the first encapsulation layer 510 and/or the third encapsulation layer 540.

In some embodiments, the second encapsulation layer 530 may contain a polymer-based material. Examples of polymer-based materials that may be used in the formation of the second encapsulation layer 530 may include polyethylene terephthalate, polyethylene naphthalate, polycarbonate, polyimide, polyethylene sulfonate, polyoxymethylene, polyarylate, hexamethyldisiloxane, acrylic resin (e.g., polymethyl methacrylate, polyacrylic acid, or the like), or any combination thereof, but are not limited thereto.

In some embodiments, the second encapsulation layer 530 may be formed by applying a monomer having flowability and then curing the monomer layer by using heat or ultraviolet rays. In some examples, the second encapsulation layer 530 may be formed by applying the above-described polymer-based material.

In some embodiments, the thickness of the second encapsulation layer 530 may be greater than that of each of the first encapsulation layer 510 and the third encapsulation layer 540. In some embodiments, each of the first encapsulation layer 510 and the third encapsulation layer 540 may have a thickness of about 600 nm (6000 Å) to about 2200 nm (22000 Å), and the second encapsulation layer 530 may have a thickness of about 3000 nm (30000 Å) to about 5000 nm (50000 Å), but they are not limited thereto.

The fourth encapsulation layer 520 may be interposed between the first encapsulation layer 510 and the second encapsulation layer 530. In some embodiments, the fourth encapsulation layer 520 may not have moisture permeability. The fourth encapsulation layer 520 may control a material forming the second encapsulation layer 530 during the process of forming the second encapsulation layer 530, including a process of applying and curing a monomer.

In some embodiments, the fourth encapsulation layer 520 may contain an inorganic insulating material. For example, the fourth encapsulation layer 520 may contain the same non-metallic element as the first encapsulation layer 510, or may contain a different element from the non-metallic element contained in the first encapsulation layer 510. For example, the fourth encapsulation layer 520 may contain silicon oxynitride (SiON).

In some embodiments, the ratio of the contents of silicon (Si), oxygen (O), and nitrogen (N) contained in the fourth encapsulation layer 520 may be different from the ratio of the contents of silicon (Si), oxygen (O), and nitrogen (N) contained in the first encapsulation layer 510 (or at least one inorganic encapsulation layer constituting the first encapsulation layer 510). In some embodiments, the content of oxygen (O) contained in the fourth encapsulation layer 520 may be higher than the content of oxygen (O) contained in the first encapsulation layer 510. For example, the fourth encapsulation layer 520 may be an inorganic insulating layer, such as an O-rich silicon oxynitride layer, with a higher oxygen content than the first encapsulation layer 510. The refractive index of the fourth encapsulation layer 520 may be lower than the refractive index of the first encapsulation layer 510.

In some embodiments, the fourth encapsulation layer 520 may be a layer that has no separate optical function, and the refractive index of the fourth encapsulation layer 520 may be substantially the same as or similar to the refractive index of the second encapsulation layer 530. In some embodiments, the difference value between the refractive index of the fourth encapsulation layer 520 and the refractive index of the second encapsulation layer 530 may be 0.05 or less. In some embodiments, the refractive index of the fourth encapsulation layer 520 may be approximately 1.49 and the refractive index of the second encapsulation layer 530 may be approximately 1.52, but they are not limited thereto.

In some embodiments, the fourth encapsulation layer 520 may be a thin film having a relatively small thickness. In some embodiments, the thickness of the fourth encapsulation layer 520 may have a value in the range of (e.g., be in the range of) approximately 20 nm (200 Å) to approximately 100 nm (1000 Å), but is not limited thereto.

Light emitted from the light-emitting element ED of each of the pixels PX may pass through the capping layer 300, the low refractive layer 400, and the encapsulation layer 500 to be emitted to the outside of the display device 10. In embodiments, by adjusting the structure, refractive index, thickness, and/or the like of the capping layer 300, the low refractive layer 400, and the encapsulation layer 500 located on the emission path of light generated by the light-emitting element ED, it is possible to increase or optimize the light efficiency due to the resonance of light emitted from each pixel PX, and to reduce or minimize the amount of movement (e.g., change) in an overall color temperature direction on a minimum perceptible color difference (hereinafter referred to as MPCD). Accordingly, it is possible to improve the light efficiency of the pixels PX, the trajectory of a white appearance difference (hereinafter referred to as WAD) of the display device 10, and the side viewing characteristics. A detailed description thereof will be given later.

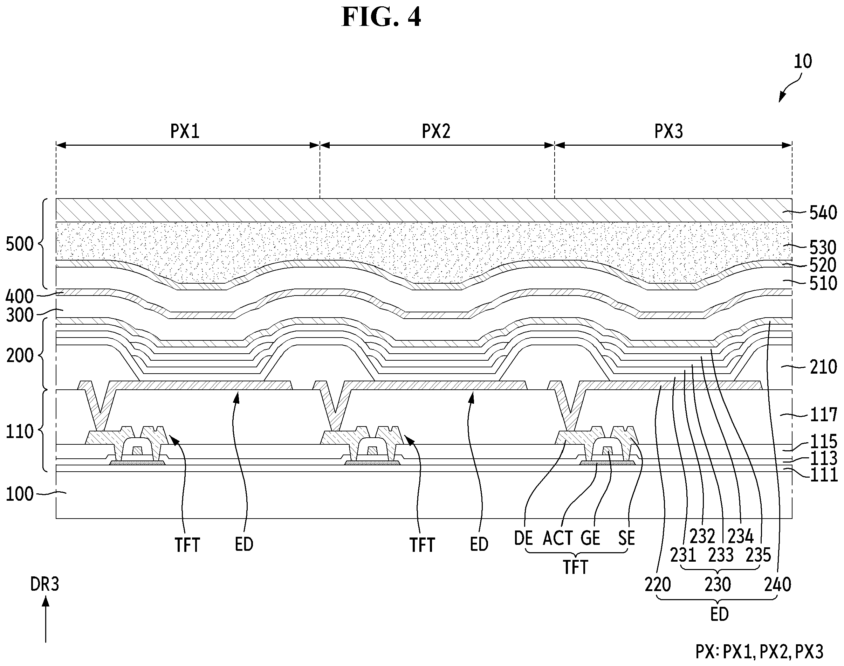

FIG. 4 is a cross-sectional view illustrating a display device according to some embodiments of the present invention. For example, FIG. 4 shows a cross section of a portion of the display device 10 in which the first pixel PX1, the second pixel PX2, and the third pixel PX3 are disposed. Compared to FIG. 3, FIG. 4 shows some other embodiments of the light-emitting elements ED.

Referring to FIGS. 1 to 4, the light-emitting elements ED may have a structure of two or more tandems (e.g., two or more similar structures or aspects) including at least two light-emitting layers 232 and 234. For example, the intermediate layer 230 of each of the light-emitting elements ED may include the first functional layer 231, the first light-emitting layer 232, a third functional layer 233, a second light-emitting layer 234, and a second functional layer 235 sequentially disposed between the first electrode 220 and the second electrode 240. As the light-emitting elements ED include at least two light-emitting layers 232 and 234, the amount of light generated by each light-emitting element ED may increase. Accordingly, the light emission amount or luminance of the light-emitting elements ED may be improved.

The first functional layer 231 and the second functional layer 235 of FIG. 4 may correspond to the first functional layer 231 and the second functional layer 235 of FIG. 3, respectively. A redundant description of the first functional layer 231 and the second functional layer 235 is omitted.

In some embodiments, the first light-emitting layer 232 and the second light-emitting layer 234 of each of the light-emitting elements ED may emit light of a specific color corresponding to each pixel PX. In some embodiments, the first light-emitting layer 232 and the second light-emitting layer 234 of each of the light-emitting elements ED may be individually disposed in each pixel area corresponding to each pixel PX. In some embodiments, the first light-emitting layer 232 of FIG. 4 may correspond to the light-emitting layer 232 of FIG. 3. Accordingly, the same reference numeral has been assigned to the first light-emitting layer 232 of FIG. 4 and the light-emitting layer 232 of FIG. 3. The second light-emitting layer 234 of FIG. 4 may be an additional light-emitting layer of the light-emitting element ED.

In some embodiments, the first light-emitting layer 232 and the second light-emitting layer 234 included in the light-emitting element ED of the first pixel PX1 may be organic light-emitting layers that emit light of the first color (e.g., red), and may contain the same or different materials. The first light-emitting layer 232 and the second light-emitting layer 234 included in the light-emitting element ED of the second pixel PX2 may be organic light-emitting layers that emit light of the second color (e.g., green), and may contain the same or different materials. The first light-emitting layer 232 and the second light-emitting layer 234 included in the light-emitting element ED of the third pixel PX3 may be organic light-emitting layers that emit light of the third color (e.g., blue), and may contain the same or different materials.

The third functional layer 233 may be disposed between the first light-emitting layer 232 and the second light-emitting layer 234 of each of the light-emitting elements ED. In some embodiments, the third functional layer 233 may include a charge generation layer.

The charge generation layer may inject charges into the first light-emitting layer 232 and the second light-emitting layer 234 of each of the light-emitting elements ED, and may adjust the charge balance between the first light-emitting layer 232 and the second light-emitting layer 234. In some embodiments, the third functional layer 233 may include an n-type charge generation layer and a p-type charge generation layer. In some embodiments, the charge generation layer may be a common layer disposed over the entire display area DA.

In some embodiments, the third functional layer 233 may further include a hole injection layer. In some embodiments, the hole injection layer of each of the light-emitting elements ED may be individually disposed in each pixel area corresponding to each pixel PX.

Although FIG. 4 illustrates the light-emitting elements ED with a two-tandem structure, each of the light-emitting elements ED may be formed in a structure of three or more tandems including three or more light-emitting layers. In addition, FIG. 4 illustrates some embodiments in which each of the light-emitting elements ED of the first pixel PX1, the second pixel PX2, and the third pixel PX3 is formed in a structure of two or more tandems, but the embodiments are not limited thereto. For example, only some of the light-emitting elements ED of the first pixel PX1, the second pixel PX2, and the third pixel PX3 may be formed in a structure of two or more tandems.

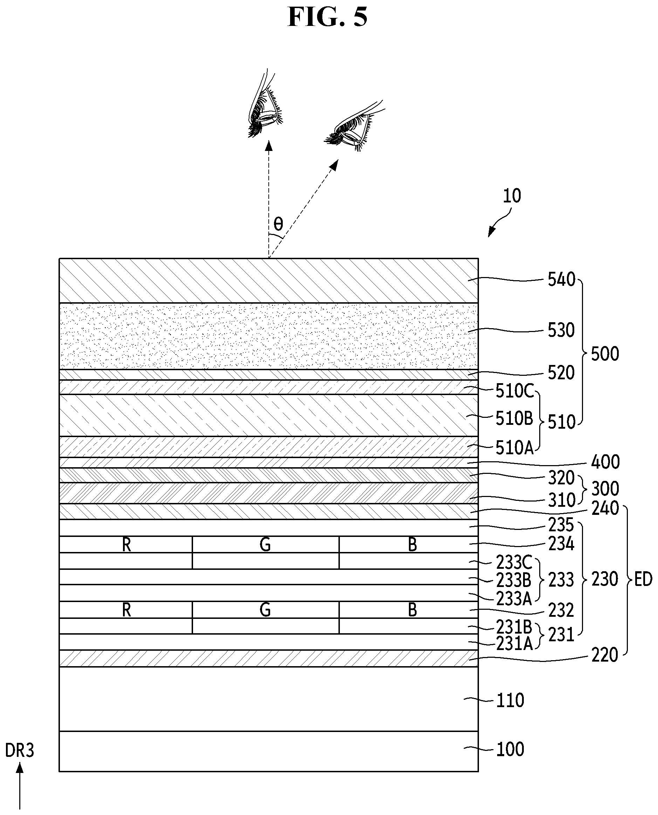

FIG. 5 is a schematic diagram schematically showing a display device according to some embodiments of the present invention. For example, FIG. 5 illustrates the light-emitting elements ED, and the capping layer 300, the low refractive layer 400, and the encapsulation layer 500 disposed on the light-emitting elements ED, according to some embodiments.

Referring to FIGS. 1 to 5, the display device 10 according to some embodiments may include the substrate 100, the pixel circuit layer 110, the light-emitting elements ED (or the light-emitting element layer 200 including the light-emitting elements ED and the pixel defining film 210), the capping layer 300 (e.g., a multi-capping layer), the low refractive layer 400, and the encapsulation layer 500 (e.g., multiple encapsulation layers) sequentially disposed on the substrate 100.

Each of the light-emitting elements ED may include the first electrode 220, the intermediate layer 230, and the second electrode 240 sequentially disposed or stacked along the third direction DR3. In some embodiments, the light-emitting elements ED may be formed in a two-tandem structure as shown in FIGS. 4 and 5. For example, the intermediate layer 230 of each of the light-emitting elements ED may include the first functional layer 231, the first light-emitting layer 232, the third functional layer 233, the second light-emitting layer 234, and the second functional layer 235 sequentially stacked on the first electrode 220. However, the embodiments are not limited thereto. For example, as shown in FIG. 3, the light-emitting elements ED may be formed in a one-tandem structure including a single light-emitting layer 232 (e.g., the first light-emitting layer 232), and may not include (e.g.,omit) the third functional layer 233 and the second light-emitting layer 234.

In some embodiments, the first functional layer 231 may be formed as multiple layers including a hole transport layer 231A and a first hole injection layer 231B. The hole transport layer 231A may be a common layer formed over the entire display area DA. The first hole injection layer 231B may be individually formed in each pixel area (e.g., the emission area of each pixel PX). In some embodiments, the first hole injection layer 231B may be improved or optimized for each pixel PX or for each light-emitting element ED according to the characteristics of the first light-emitting layer 232 of each of the light-emitting elements ED. For example, the thickness, material, and the like of the first hole injection layer 231B formed in each of the first pixel PX1, the second pixel PX2, and the third pixel PX3 may be differentiated or improved or optimized so as to improve the light emission characteristics of each of a red light-emitting layer R, a green light-emitting layer G, and a blue light-emitting layer B.

In some embodiments, the second functional layer 235 may be formed as a single layer or multiple layers, including an electron transport layer. For example, the second functional layer 235 may include an electron transport layer, or may include an electron transport layer, an electron injection layer, and the like.

In some embodiments, the third functional layer 233 may include an n-type charge generation layer 233A and a p-type charge generation layer 233B. The n-type charge generation layer 233A may be disposed between the p-type charge generation layer 233B and the first light-emitting layers 232 of the light-emitting elements ED. The p-type charge generation layer 233B may be disposed between the n-type charge generation layer 233A and the second light-emitting layers 234 of the light-emitting elements ED. The n-type charge generation layer 233A and the p-type charge generation layer 233B may be a common layer formed over the entire display area DA.

The n-type charge generation layer 233A may supply electrons to the first light-emitting layers 232 of the light-emitting elements ED. The p-type charge generation layer 233B may supply holes to the second light-emitting layers 234 of the light-emitting elements ED. Accordingly, the light emission efficiency of the light-emitting elements ED may be increased and the driving voltage may be reduced.

In some embodiments, the third functional layer 233 may further include a second hole injection layer 233C disposed between the p-type charge generation layer 233B and the second light-emitting layer 234. In some embodiments, the second hole injection layer 233C may be individually formed in each pixel area (e.g., the emission area of each pixel PX). In some embodiments, the second hole injection layer 233C may be optimized or substantially improved for each pixel PX or for each light-emitting element ED so as to improve the light efficiency of each of the light-emitting elements ED. For example, the thickness, material, and the like of the second hole injection layer 233C formed in each of the first pixel PX1, the second pixel PX2, and the third pixel PX3 may be differentiated or optimized or substantially improved so as to improve the light emission characteristics of each of the red light-emitting layer R, the green light-emitting layer G, and the blue light-emitting layer B. In some embodiments, the thickness of the second hole injection layer 233C formed in each of the first pixel PX1, the second pixel PX2, and the third pixel PX3 may be differentiated or substantially improved or optimized so as to increase or maximize the resonance effect of light emitted from each of the light-emitting elements ED of the first pixel PX1, the second pixel PX2, and the third pixel PX3. For example, the second hole injection layers 233C included in the light-emitting elements ED of the first pixel PX1, the second pixel PX2, and the third pixel PX3 may have different thicknesses, and the thickness of each of the second hole injection layers 233C may be adjusted to correspond to a resonance distance of light emitted from the light-emitting elements ED of the first pixel PX1, the second pixel PX2, and the third pixel PX3. Accordingly, the light efficiency of the first pixel PX1, the second pixel PX2, and the third pixel PX3 may be improved.

The first light-emitting layer 232 and the second light-emitting layer 234 of each of the light-emitting elements ED may emit light of a color corresponding to each pixel PX. In some embodiments, the first light-emitting layer 232 and the second light-emitting layer 234 included in the light-emitting element ED of each pixel PX may emit light in the same or similar wavelength band. For example, the first light-emitting layer 232 and the second light-emitting layer 234 included in the light-emitting element ED of the first pixel PX1 may be the red light-emitting layers R that emit light in a red wavelength band. The first light-emitting layer 232 and the second light-emitting layer 234 included in the light-emitting element ED of the second pixel PX2 may be the green light-emitting layers G that emit light in a green wavelength band. The first light-emitting layer 232 and the second light-emitting layer 234 included in the light-emitting element ED of the third pixel PX3 may be the blue light-emitting layers B that emit light in a blue wavelength band.

The capping layer 300 may include a first capping layer 310 and a second capping layer 320 sequentially disposed in a light traveling direction (or, in a direction from the light-emitting element layer 200 including the light-emitting elements ED toward the encapsulation layer 500). For example, the first capping layer 310 may be disposed on the second electrode 240 of the light-emitting elements ED, and the second capping layer 320 may be disposed on the first capping layer 310.

In some embodiments, the capping layer 300 may be disposed directly on the second electrode 240 of the light-emitting elements ED and may have a double-layer structure consisting of the first capping layer 310 and the second capping layer 320. For example, the first capping layer 310 may be disposed directly on the second electrode 240 of the light-emitting elements ED, and the second capping layer 320 may be disposed directly on the first capping layer 310. In addition, the low refractive layer 400 may be disposed directly on the second capping layer 320.

The first capping layer 310 and the second capping layer 320 may have different refractive indices. For example, the first capping layer 310 may have a first refractive index and the second capping layer 320 may have a second refractive index that is different from the first refractive index.

In some embodiments, the difference value (e.g., difference) between the first refractive index and the second refractive index may be about 0.2 or more. Accordingly, the resonance of light emitted from the light-emitting elements ED may be appropriately or effectively enhanced. For example, if the difference value between the first refractive index and the second refractive index is less than 0.2, it may be difficult to achieve a significant resonance effect, or the resonance effect may be reduced.

In some embodiments, the second refractive index of the second capping layer 320 may be lower than the first refractive index of the first capping layer 310. For example, the first refractive index may have a value in the range of about 1.2 to about 3.0, and the second refractive index may have a value in the range of about 1.0 to about 2.8. The refractive index range of the first capping layer 310 and the second capping layer 320 may vary depending on the materials used for forming the first capping layer 310 and the second capping layer 320, and the first capping layer 310 and the second capping layer 320 may be formed such that the difference value between the first refractive index and the second refractive index is about 0.2 or greater. In describing embodiments, the exemplified range of the refractive index may be based on the refractive index for light in the green wavelength band, e.g., visible light at a wavelength of approximately 550 nm, but the embodiments are not limited thereto.

In some embodiments, the first capping layer 310 and the second capping layer 320 may contain an inorganic insulating material. For example, the first capping layer 310 and the second capping layer 320 may each contain aluminum oxide (e.g., Al₂O₃), titanium oxide (e.g., TiO₂), tantalum oxide (e.g., Ta₂O₅), hafnium oxide (e.g., HfO₂), zinc oxide (ZnO), silicon oxide (SiOₓ), silicon nitride (SiNₓ), silicon oxynitride (SiON), and/or other inorganic insulating materials. However, the embodiments are not limited thereto. For example, at least one of the first capping layer 310 or the second capping layer 320 may contain an organic insulating material.

Each of the first capping layer 310 and the second capping layer 320 may have a refractive index in the range exemplified above. In addition, the first capping layer 310 may contain a high refractive material (e.g., silicon nitride (SiNₓ), silicon oxynitride (SiON) having a higher nitrogen (N) content than the second capping layer 320, zinc oxide (ZnO), zirconium oxide (e.g., ZrO₂), titanium oxide (e.g., TiO₂), and/or other high refractive materials) having a higher refractive index than the second capping layer 320. For example, the first capping layer 310 and the second capping layer 320 may contain different materials, or may contain materials having different contents of specific elements.

The low refractive layer 400 may have a refractive index lower than that of the capping layer 300. For example, the low refractive layer 400 may have a third refractive index that is lower than the first refractive index of the first capping layer 310 and the second refractive index of the second capping layer 320.

In some embodiments, the difference value between the second refractive index and the third refractive index may be 0.2 or more. Accordingly, the resonance of light emitted from the light-emitting elements ED may be appropriately or effectively enhanced. For example, if the difference value between the second refractive index and the third refractive index is less than about 0.2, it may be difficult to achieve a significant resonance effect, or the resonance effect may be reduced. In some embodiments, the third refractive index of the low refractive layer 400 may have a value of about 1.6 or less, but is not limited thereto. The refractive index range of the low refractive layer 400 may vary depending on the refractive index materials used for forming the low refractive layer 400, and the second capping layer 320 and the low refractive layer 400 may be formed such that the difference value between the second refractive index and the third refractive index is about 0.2 or greater.

By adjusting the refractive index and thickness of the first capping layer 310, the second capping layer 320, and the low refractive layer 400, the optical characteristics of the pixels PX may be adjusted or improved. For example, the refractive indices and thicknesses of the first capping layer 310, the second capping layer 320, and the low refractive layer 400 may be adjusted so as to enhance the resonance of light emitted from the light-emitting elements ED of the pixels PX, while reducing the interfacial reflection that occurs on the traveling path of the light (e.g., interfacial reflection occurring at the interface between the first capping layer 310 and the second capping layer 320, and interfacial reflection occurring at the interface between the second capping layer 320 and the low refractive layer 400). In some embodiments, as the refractive index gradually decreases in the order of the first capping layer 310, the second capping layer 320, and the low refractive layer 400, the difference in refractive index at the interface between consecutive films may be reduced and the interfacial reflection may be weakened. Accordingly, the light efficiency of the pixels PX may be increased, and the color dispersion or the like of light according to the side viewing angle may be reduced.

In some embodiments, the first capping layer 310 may be formed as a high refractive layer having a refractive index greater than about 1.6. For example, the refractive index of the first capping layer 310 may have a value (e.g., approximately 2.1) in the range of approximately 1.61 to approximately 2.3. As the first capping layer 310 has a refractive index greater than 1.6, it is possible to broaden the range of material choices for forming the second capping layer 320 and the low refractive layer 400. However, the embodiments are not limited thereto. For example, the refractive index of the first capping layer 310 may be adjusted or changed in the refractive index range (approximately 1.2 to approximately 3.0) exemplified above.

In some embodiments, the first capping layer 310 may have a thickness ranging from approximately 20 nm (200 Å) to approximately 140 nm (1400 Å). For example, the thickness of the first capping layer 310 may range from approximately 20 nm (200 Å) to approximately 100 nm (1000 Å). In some embodiments, considering the function of the first capping layer 310 and the light efficiency of the pixels PX, the thickness of the first capping layer 310 may be appropriately adjusted or optimized or substantially improved. For example, if the thickness of the first capping layer 310 is less than about 20 nm (200 Å), there is a risk of degradation in the function of the first capping layer 310, and if the thickness of the first capping layer 310 is greater than about 140 nm (1400 Å), there may be a risk of reduced light efficiency of the pixels PX.

In some embodiments, the refractive index of the second capping layer 320 may have a value in the range of approximately 1.1 to approximately 1.8, or more narrowly in the range of approximately 1.41 to approximately 1.6. In some embodiments, the second capping layer 320 may be made of lithium quinolate (Liq) having a refractive index of approximately 1.6. However, the embodiments are not limited thereto. For example, the refractive index of the second capping layer 320 may be adjusted or changed in the refractive index range (approximately 1.0 to approximately 2.8) exemplified above. The second capping layer 320 may contain a material having a refractive index in the exemplified range.

In some embodiments, the second capping layer 320 may have a thickness ranging from approximately 5 nm (50 Å) to approximately 100 nm (1000 Å). For example, the thickness of the second capping layer 320 may range from approximately 5 nm (50 Å) to approximately 80 nm (800 Å). The thickness of the second capping layer 320 may be smaller than the thickness of the first capping layer 310, but is not limited thereto. In some embodiments, considering the function of the second capping layer 320 and the light efficiency of the pixels PX, the thickness of the second capping layer 320 may be appropriately adjusted or optimized or substantially improved. For example, if the thickness of the second capping layer 320 is less than about 5 nm (50 Å), there is a risk of degradation in the function of the second capping layer 320, and if the thickness of the second capping layer 320 is greater than about 100 nm (1000 Å), there may be a risk of reduced light efficiency of the pixels PX.

In some embodiments, the refractive index of the low refractive layer 400 may be about 1.6 or less. For example, the refractive index of the low refractive layer 400 may have a value ranging from approximately 1.3 to approximately 1.6. The low refractive layer 400 may contain lithium fluoride (LiF) or Liq. In some other embodiments, the low refractive layer 400 may contain a low refractive material (e.g., aluminum(III) bis(2-methyl-8-quninolinato)-4-phenylphenolate(BAlq), silicon oxide (SiOₓ), or the like) other than LiF or Liq. In some embodiments, the low refractive layer 400 may be made of LiF having a refractive index of approximately 1.36 or approximately 1.4. However, the embodiments are not limited thereto. For example, the refractive index of the low refractive layer 400 may be adjusted or changed in a range smaller than the refractive index of the second capping layer 320. The low refractive layer 400 may contain a low refractive material having a refractive index lower than that of the second capping layer 320.

In some embodiments, the refractive index of the low refractive layer 400 may be lower than the refractive index of the first encapsulation layer 510 or the refractive index of at least one inorganic encapsulation layer constituting the first encapsulation layer 510. For example, the refractive index of the low refractive layer 400 may be lower than the refractive index of a first inorganic encapsulation layer 510A.

The difference value between the refractive index of the low refractive layer 400 and the refractive index of the encapsulation layer 500 may be greater than the difference value between the refractive index of the capping layer 300 and the refractive index of the encapsulation layer 500. For example, the difference value between the refractive index of the low refractive layer 400 and the refractive index of the first inorganic encapsulation layer 510A may be greater than the difference value between the refractive index of the second capping layer 320 and the refractive index of the first inorganic encapsulation layer 510A. By disposing the low refractive layer 400 between the second capping layer 320 and the first inorganic encapsulation layer 510A, the resonance of light emitted from the light-emitting elements ED may be enhanced, thereby increasing the light emission efficiency of the pixels PX.

In some embodiments, the low refractive layer 400 may have a thickness ranging from approximately 20 nm (200 Å) to approximately 100 nm (1000 Å). For example, the thickness of the low refractive layer 400 may be approximately 40 nm (400 Å). In some embodiments, considering the function of the low refractive layer 400 and the light efficiency of the pixels PX, the thickness of the low refractive layer 400 may be appropriately adjusted or optimized or substantially improved. For example, if the thickness of the low refractive layer 400 is less than about 20 nm (200 Å), there is a risk of degradation in the function of the low refractive layer 400, and if the thickness of the low refractive layer 400 is greater than about 100 nm (1000 Å), there may be a risk of reduced light efficiency of the pixels PX.

As described above, in embodiments, the multi-capping layer 300, including the first capping layer 310 and the second capping layer 320, and the low refractive layer 400 may be disposed between the light-emitting element layer 200 and the encapsulation layer 500. Accordingly, the optical characteristics of the pixels PX may be more precisely controlled or improved. For example, by disposing multilayer films of three or more layers, including the multi-capping layer 300 and the low refractive layer 400, between the second electrode 240 of the light-emitting elements ED and the encapsulation layer 500, and adjusting the refractive index or thickness of each of the first capping layer 310, the second capping layer 320, and the low refractive layer 400, it is possible to more finely control the resonance distance or interface reflection corresponding to a wavelength band of light emitted from each of the light-emitting elements ED of the first pixel PX1, the second pixel PX2, and the third pixel PX3.

Accordingly, the optical characteristics of the pixels PX may be appropriately controlled, improved, or optimized. For example, the resonance of light emitted from the light-emitting elements ED of the first pixel PX1, the second pixel PX2, and the third pixel PX3 may be appropriately or suitably controlled to increase the resonance effect and reduce the interfacial reflection that may occur on the traveling path of the light. As a result, the light efficiency of the pixels PX may be improved, and the dispersion of color changes may be reduced to improve or optimize the WAD and improve the side viewing characteristics of the display device 10.

The encapsulation layer 500 may include the first encapsulation layer 510, the second encapsulation layer 530, and the third encapsulation layer 540 disposed sequentially in a light traveling direction (or, in a direction from the light-emitting element layer 200 toward the encapsulation layer 500). In some embodiments, the encapsulation layer 500 may further include the fourth encapsulation layer 520 disposed between the first encapsulation layer 510 and the second encapsulation layer 530.

As described above, the first encapsulation layer 510 according to some embodiments may be formed as multiple layers including at least two films with different refractive indices. For example, the first encapsulation layer 510 may include the first inorganic encapsulation layer 510A disposed on the low refractive layer 400 and having a fourth refractive index, a second inorganic encapsulation layer 510B disposed on the first inorganic encapsulation layer 510A and having a fifth refractive index, and a third inorganic encapsulation layer 510C disposed on the second inorganic encapsulation layer 510B and having a sixth refractive index.

In some embodiments, the fourth refractive index of the first inorganic encapsulation layer 510A may be higher than the third refractive index of the low refractive layer 400. For example, the fourth refractive index may be about 0.2 or more higher than the third refractive index. Accordingly, the resonance of light emitted from the light-emitting elements ED may be appropriately or effectively enhanced. For example, if the difference value between the third refractive index and the fourth refractive index is less than about 0.2, it may be difficult to achieve a significant resonance effect, or the resonance effect may be reduced.

In some embodiments, the refractive index of the first encapsulation layer 510 may vary gradually. For example, the fifth refractive index of the second inorganic encapsulation layer 510B may be lower than the fourth refractive index of the first inorganic encapsulation layer 510A, and the sixth refractive index of the third inorganic encapsulation layer 510C may be lower than the fifth refractive index of the second inorganic encapsulation layer 510B. Accordingly, the interfacial reflection occurring in the first encapsulation layer 510 may be reduced or weakened.

In some embodiments, each of the first inorganic encapsulation layer 510A, the second inorganic encapsulation layer 510B, and the third inorganic encapsulation layer 510C may be an inorganic insulating layer containing a non-metallic element (e.g., silicon (Si), oxygen (O), and/or nitrogen (N)), and may contain, for example, silicon oxide (SiOₓ), silicon nitride (SiNₓ), silicon oxynitride (SiON), and/or the like. In addition, the numbers, types, and/or contents of non-metallic elements contained in the first inorganic encapsulation layer 510A, the second inorganic encapsulation layer 510B, and the third inorganic encapsulation layer 510C may be different from each other, and accordingly, the first inorganic encapsulation layer 510A, the second inorganic encapsulation layer 510B, and the third inorganic encapsulation layer 510C may have different refractive indices.

In some embodiments, the first inorganic encapsulation layer 510A may contain silicon nitride (SiNₓ), and the fourth refractive index of the first inorganic encapsulation layer 510A may be about 1.77 or more. For example, the fourth refractive index may have a value (e.g., approximately 1.89) in the range of approximately 1.8 to approximately 2.3, but is not limited thereto. The number, type, and/or content of non-metallic elements contained in the first inorganic encapsulation layer 510A may be the same as or different from the number, type, and/or content of non-metallic elements contained in the third encapsulation layer 540. In addition, the fourth refractive index of the first inorganic encapsulation layer 510A may be the same as or different from the refractive index of the third encapsulation layer 540.

In some embodiments, the first inorganic encapsulation layer 510A may have a thickness ranging from approximately 600 Å to approximately 1800 Å. For example, the thickness of the first inorganic encapsulation layer 510A may be approximately 125 nm (1250 Å), but is not limited thereto.

In some embodiments, the second inorganic encapsulation layer 510B may contain silicon oxynitride (SiON), and the fifth refractive index of the second inorganic encapsulation layer 510B may be less than about 1.77. For example, the fifth refractive index may have a value (e.g., approximately 1.62) in the range of approximately 1.6 to approximately 1.76, but is not limited thereto.

In some embodiments, the second inorganic encapsulation layer 510B may have a thickness greater than the thickness of the first inorganic encapsulation layer 510A and the third inorganic encapsulation layer 510C. For example, the second inorganic encapsulation layer 510B may have a thickness ranging from approximately 600 nm (6000 Å) to approximately 2000 nm (20000 Å). For example, the thickness of the second inorganic encapsulation layer 510B may be approximately 870 nm (8700 Å), but is not limited thereto.

When the thickness of the second inorganic encapsulation layer 510B is about 600 nm (6000 Å) or more, moisture permeation may be prevented or substantially reduced in advance, and when the thickness of the second inorganic encapsulation layer 510B is about 2200 nm (22000 Å) or less, peeling or separation of the second inorganic encapsulation layer 510B may be prevented in advance or substantially reduced.

In some embodiments, the third inorganic encapsulation layer 510C may contain silicon oxynitride (SiON), and the content of nitrogen (N) contained in the second inorganic encapsulation layer 510B may be different from the content of nitrogen (N) contained in the third inorganic encapsulation layer 510C. Accordingly, the refractive indices of the second inorganic encapsulation layer 510B and the third inorganic encapsulation layer 510C may be different. In some embodiments, the content of nitrogen (N) contained in the second inorganic encapsulation layer 510B may be higher than the content of nitrogen (N) contained in the third inorganic encapsulation layer 510C, and the fifth refractive index of the second inorganic encapsulation layer 510B may be higher than the sixth refractive index of the third inorganic encapsulation layer 510C.

In some embodiments, the sixth refractive index of the third inorganic encapsulation layer 510C may be less than about 1.6. For example, the sixth refractive index of the third inorganic encapsulation layer 510C may have a value (e.g., approximately 1.57) in the range of approximately 1.4 to approximately 1.59, but is not limited thereto.

In some embodiments, the third inorganic encapsulation layer 510C may have a thickness of about 100 nm (1000 Å) or less. For example, the third inorganic encapsulation layer 510C may have a thickness ranging from approximately 40 nm (400 Å) to approximately 100 nm (1000 Å). For example, the thickness of the third inorganic encapsulation layer 510C may be approximately 70 nm (700 Å), but is not limited thereto. As the third inorganic encapsulation layer 510C may have a thickness of about 100 nm (1000 Å) or less, the formation thickness of the third inorganic encapsulation layer 510C may be suitably controlled.

The first inorganic encapsulation layer 510A, the second inorganic encapsulation layer 510B, and the third inorganic encapsulation layer 510C may have refractive indices and thicknesses in the ranges described above to reduce or weaken the interfacial reflection occurring on the traveling path of light emitted from the light-emitting elements ED of the pixels PX, and to prevent or minimize or substantially reduce the increase in dispersion on the MPCD when viewed in a direction (e.g., the third direction DR3) perpendicular to the substrate 100 and in a lateral direction oblique to the substrate 100 due to a thin film interference phenomenon occurring in the encapsulation layer 500. For example, by forming the first encapsulation layer 510 into multiple layers including the first inorganic encapsulation layer 510A, the second inorganic encapsulation layer 510B, and the third inorganic encapsulation layer 510C according to some embodiments, it is possible to prevent or minimize or substantially reduce an increase in the amount of movement in the overall color temperature direction and reduce dispersion on color coordinates.

According to some embodiments, by disposing the multi-capping layer 300, including the first capping layer 310 and the second capping layer 320, and the low refractive layer 400 between the light-emitting element layer 200 and the encapsulation layer 500, the optical characteristics of the pixels PX may be more precisely controlled or improved. For example, the resonance of light emitted from the light-emitting elements ED of the first pixel PX1, the second pixel PX2, and the third pixel PX3 may be appropriately controlled or enhanced to increase the luminance of the pixels PX, and to reduce or weaken the interfacial reflection that may occur on the traveling path of the light. As a result, the light efficiency of the pixels PX may be improved, and color dispersion depending on the side viewing angle may be reduced to improve the side viewing characteristics of the display device 10.

Although FIGS. 3 to 5 illustrate embodiments in which the display device 10 includes the low refractive layer 400, the embodiments are not limited thereto. For example, the display device 10 may not include (e.g., omit) the low refractive layer 400 if the resonance effect of light emitted from the light-emitting elements ED is adequately or sufficiently secured by the multi-capping layer 300. For example, the display device 10 may include the multi-capping layer 300 disposed between the light-emitting elements ED and the encapsulation layer 500 and including at least two films with different refractive indices, and the low refractive layer 400 may or may not be disposed between the multi-capping layer 300 and the encapsulation layer 500. In some other embodiments, the low refractive layer 400 may be an element included in the capping layer 300 and may contain a low refractive material that has a relatively low refractive index compared to at least one other film included in the capping layer 300.

In addition, according to some embodiments, by forming the first encapsulation layer 510 into multiple layers including at least two films with different refractive indices, it is possible to prevent or substantially reduce the probability of significant dispersion on the MPCD due to a thin film interference phenomenon. Accordingly, the optical characteristics of the pixels PX may be further improved.

By adjusting the refractive indices and thicknesses of the films included in the capping layer 300, the low refractive layer 400, and the first encapsulation layer 510, the optical characteristics of the pixels PX, including light emission efficiency and side viewing characteristics, may be improved or optimized. In some embodiments, the first capping layer 310 having a refractive index of approximately 2.1 and a thickness in the range of about 20 nm (200 Å) to about 100 nm (1000 Å), the second capping layer 320 (e.g., the second capping layer 320 made of Liq) having a refractive index of approximately 1.6 and a thickness in the range of about 5 nm (50 Å) to about 80 nm (800 Å), the low refractive layer 400 (e.g., the low refractive layer 400 made of LiF) having a refractive index of approximately 1.4 (or 1.36) and a thickness of approximately 40 nm (400 Å), the first inorganic encapsulation layer 510A (e.g., the first inorganic encapsulation layer 510A made of silicon nitride (SiNₓ)) having a refractive index of approximately 1.89 and a thickness of approximately 125 nm (1250 Å), the second inorganic encapsulation layer 510B (e.g., the second inorganic encapsulation layer 510B made of silicon oxynitride (SiON)) having a refractive index of approximately 1.62 and a thickness of approximately 870 nm (8700 Å), and the third inorganic encapsulation layer 510C (e.g., the third inorganic encapsulation layer 510C made of silicon oxynitride (SiON) and having a lower nitrogen (N) content than the second inorganic encapsulation layer 510B) having a refractive index of approximately 1.57 and a thickness of approximately 70 nm (700 Å) may be disposed on the second electrode 240 of the light-emitting elements ED. Accordingly, the resonance of the light emitted from the light-emitting elements ED may be enhanced, and the interfacial reflection may be reduced or weakened. The fourth encapsulation layer 520, the second encapsulation layer 530, and the third encapsulation layer 540 may be sequentially disposed on the capping layer 300, the low refractive layer 400, and the first encapsulation layer 510.

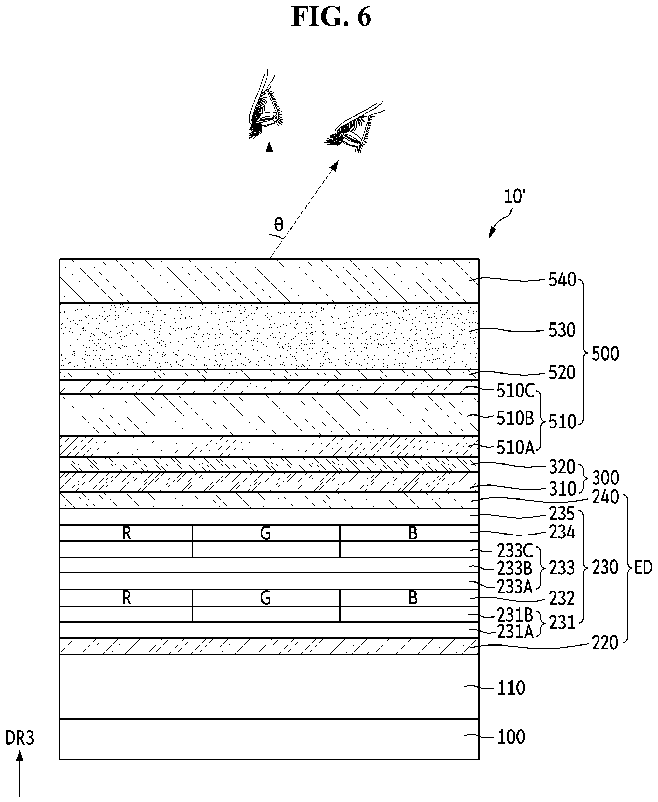

FIG. 6 is a schematic diagram schematically showing a display device according to some embodiments of the present invention. Compared to FIG. 5, FIG. 6 shows a display device 10' that does not include (e.g., omits) the low refractive layer 400 of FIG. 5.

Referring to FIG. 6, the display device 10' according to some embodiments may not include (e.g., omit) the low refractive layer 400 of FIG. 5, and the encapsulation layer 500 may be disposed directly on the capping layer 300. For example, the first inorganic encapsulation layer 510A may be disposed directly on the second capping layer 320.

In some embodiments, the refractive index of the first inorganic encapsulation layer 510A according to some embodiments of FIG. 6 may be lower than the refractive index of the first inorganic encapsulation layer 510A according to some embodiments of FIG. 5. For example, the first inorganic encapsulation layer 510A according to some embodiments of FIG. 6 may be a silicon oxynitride layer containing silicon oxynitride (SiON) and having a refractive index of approximately 1.77, while the first inorganic encapsulation layer 510A according to some embodiments of FIG. 5 may be a silicon nitride layer containing silicon nitride (SiNₓ) and having a refractive index of approximately 1.89.

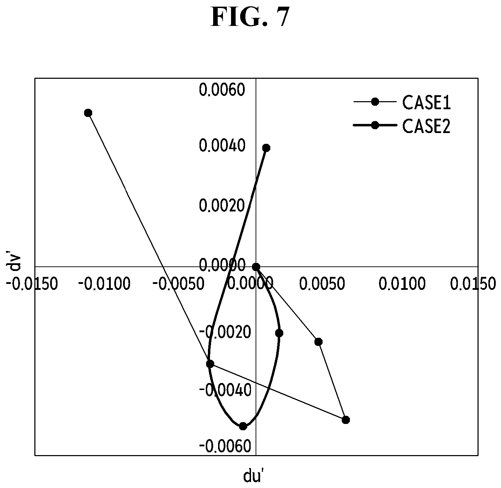

FIG. 7 is a diagram illustrating an MPCD of a display device according to some embodiments of FIGS. 5 and 6. For example, FIG. 7 shows MPCD values when viewing the display devices 10 and 10' according to some embodiments of FIGS. 5 and 6 at angles (e.g., θ in FIGS. 5 and 6) of 0°, 15°, 30°, 45°, and 60°, with respect to the third direction DR3 (e.g., a Z direction) perpendicular to the substrate 100. In FIG. 7, the difference between colors depending on the viewing angle of the display devices 10 and 10' is shown as variations du' and dv' of a u' color coordinate and a v' color coordinate.

Referring to FIGS. 5 to 7, the variations du' and dv' of the u' color coordinate and the v' color coordinate when viewing the display devices 10 and 10' according to some embodiments of FIGS. 5 and 6 at an angle θ of 0° (e.g., in a frontal direction) with respect to the third direction DR3 may be zero. For example, when the display devices 10 and 10' according to some embodiments of FIGS. 5 and 6 are viewed in a lateral direction at an oblique angle θ of 15°, 30°, 45°, and 60° with respect to the third direction DR3, the variations du' and dv' of the u' color coordinate and the v' color coordinate may occur.

As in the embodiments of FIG. 6, in the case of the display device 10' of CASE 1, including the first capping layer 310 and the second capping layer 320 but not including the low refractive layer 400, it may be observed that a relatively large color dispersion occurs depending on the angle θ viewed from the side. For example, in the case of the display device 10' of CASE 1, which does not include (e.g., omits) the low refractive layer 400, the amount of movement in the overall color temperature direction depending on the angle θ viewed from the side may be relatively large.

On the other hand, as in some embodiments of FIG. 5, in the case of the display device 10 of CASE 2 including the first capping layer 310, the second capping layer 320, and the low refractive layer 400, it may be observed that a relatively small color dispersion occurs depending on the angle θ viewed from the side. For example, in the case of the display device 10 of CASE 2 including the low refractive layer 400, the amount of movement in the overall color temperature direction depending on the angle θ viewed from the side may be relatively small. Accordingly, the side viewing characteristics of the display device 10 may be improved.

In addition, as in some embodiments of FIG. 5, in the case of the display device 10 of CASE 2 including the low refractive layer 400, by disposing the low refractive layer 400 between the multi-capping layer 300 and the encapsulation layer 500, the resonance of light emitted from the pixels PX may be enhanced, and the interfacial reflection may be appropriately controlled or reduced. Accordingly, the straight light emitted in the frontal direction (e.g., the third direction DR3) of the display device 10 may be enhanced, and the overall light efficiency of the display device 10 may be improved.

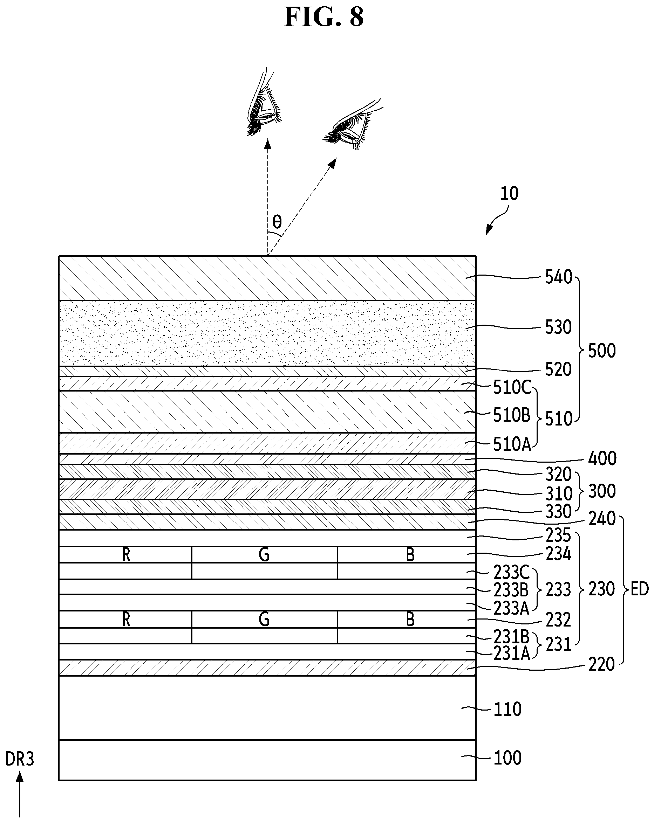

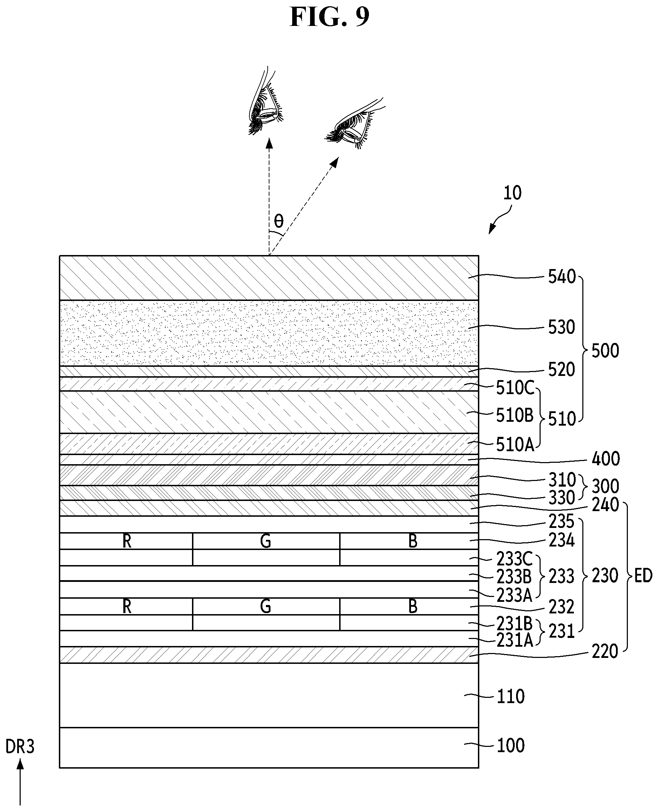

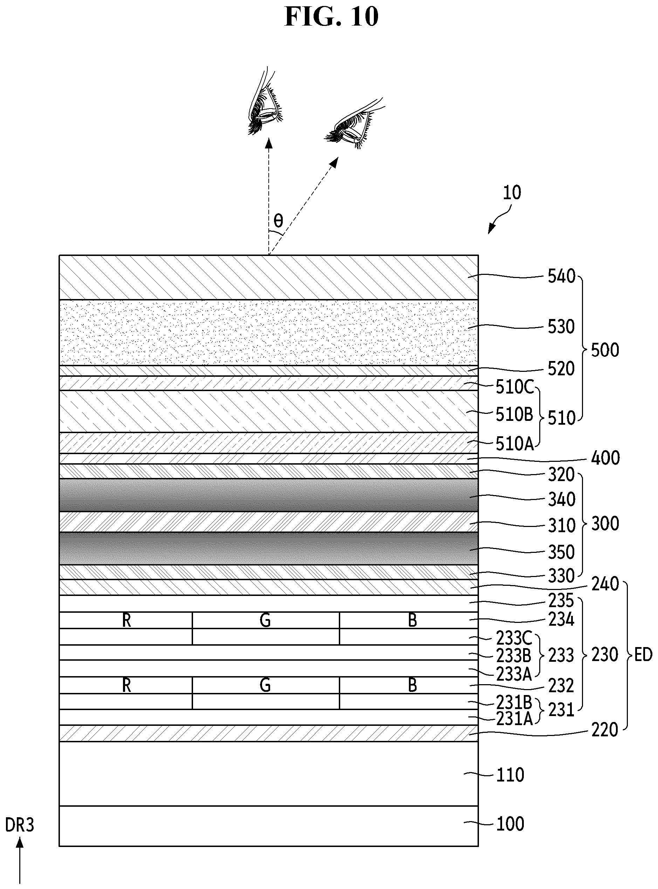

FIG. 8 is a schematic diagram schematically showing a display device according to some embodiments of the present invention. FIG. 9 is a schematic diagram schematically showing a display device according to some embodiments of the present invention. FIG. 10 is a schematic diagram schematically showing a display device according to some embodiments of the present invention. For example, FIGS. 8, 9, and 10 illustrate other embodiments of the capping layer 300 of FIG. 5.

Referring to FIG. 8, the capping layer 300 may further include a third capping layer 330 disposed between the light-emitting element layer 200 and the first capping layer 310. In some embodiments, the capping layer 300 may include the third capping layer 330, the first capping layer 310, and the second capping layer 320 sequentially disposed on the second electrode 240 of the light-emitting elements ED.

In some embodiments, the third capping layer 330 may contain an inorganic insulating material. For example, the third capping layer 330 may contain aluminum oxide (e.g., Al₂O₃), titanium oxide (e.g., TiO₂), tantalum oxide (e.g., Ta₂O₅), hafnium oxide (e.g., HfO₂), zinc oxide (ZnO), silicon oxide (SiOₓ), silicon nitride (SiNₓ), silicon oxynitride (SiON), and/or other inorganic insulating materials. However, the embodiments are not limited thereto. For example, the third capping layer 330 may contain an organic insulating material.

The refractive index of the third capping layer 330 may be different from the first refractive index of the first capping layer 310. For example, the third capping layer 330 may have a refractive index lower than the first refractive index. In some embodiments, the difference value between the refractive index of the third capping layer 330 and the first refractive index may be about 0.2 or more. For example, if the difference value between the refractive index of the third capping layer 330 and the first refractive index is less than 0.2, it may be difficult to achieve a significant resonance effect, or the resonance effect may be reduced. Accordingly, the resonance of light emitted from the light-emitting elements ED may be appropriately or effectively enhanced. The first capping layer 310 and the third capping layer 330 may contain different materials, or may contain materials having different contents of specific elements and the like.

The refractive index of the third capping layer 330 may be the same as or different from the second refractive index of the second capping layer 320. For example, the refractive index of the third capping layer 330 may be substantially the same as or similar to the second refractive index, but is not limited thereto. The second capping layer 320 and the third capping layer 330 may contain the same material or different materials.

In some embodiments, the first refractive index of the first capping layer 310 may have a value in the range of about 1.2 to about 3.0, and the second refractive index of the second capping layer 320 and the refractive index of the third capping layer 330 may have a value in the range of about 1.0 to about 2.8. The refractive index range of the first capping layer 310, the second capping layer 320 and the third capping layer 330 may vary depending on the materials used for forming the first capping layer 310, the second capping layer 320, and the third capping layer 330. The first capping layer 310, the second capping layer 320, and the third capping layer 330 may be formed such that the difference value between the first refractive index and the second refractive index is about 0.2 or greater and the difference value between the first refractive index and the third refractive index is about 0.2 or greater. In describing embodiments, the exemplified range of the refractive index may be based on the refractive index for light in the green wavelength band, e.g., visible light at a wavelength of approximately 550 nm, but the embodiments are not limited thereto.

In some embodiments, the third capping layer 330 may have a thickness ranging from approximately 5 nm (50 Å) to approximately 100 nm (1000 Å). For example, the thickness of the third capping layer 330 may range from approximately 5 nm (50 Å) to approximately 80 nm (800 Å). The thickness of the third capping layer 330 may be smaller than the thickness of the first capping layer 310, but is not limited thereto. The thickness of the third capping layer 330 may be substantially the same as or similar to the thickness of the second capping layer 320, but is not limited thereto. In some embodiments, considering the function of the third capping layer 330 and the light efficiency of the pixels PX, the thickness of the third capping layer 330 may be appropriately adjusted or optimized or substantially improved. For example, if the thickness of the third capping layer 330 is less than about 5 nm (50 Å), there is a risk of degradation in the function of the third capping layer 330, and if the thickness of the third capping layer 330 is greater than about 100 nm (1000 Å), there may be a risk of reduced light efficiency of the pixels PX.

According to the above-described embodiment, by disposing the second capping layer 320 and the third capping layer 330 having a lower refractive index than the first capping layer 310, on top and bottom of the first capping layer 310 containing a high refractive material, the resonance of light emitted from the light-emitting elements ED may be enhanced. Accordingly, the light efficiency of the pixels PX and the display device 10 including them may be improved.

Referring to FIG. 9, the capping layer 300 may not include (e.g., omit) the second capping layer 320 as in some embodiments of FIG. 8. For example, the capping layer 300 may include the third capping layer 330 and the first capping layer 310 sequentially disposed on the second electrode 240 of the light-emitting elements ED, and the low refractive layer 400 (or the encapsulation layer 500) may be disposed on the first capping layer 310.

Even in the above-described embodiment, by disposing the multi-capping layer 300, including the third capping layer 330 and the first capping layer 310 with different refractive indices, between the light-emitting elements ED and the encapsulation layer 500, the resonance of light emitted from the light-emitting elements ED may be appropriately controlled or enhanced. Accordingly, the light efficiency of the pixels PX and the display device 10 including them may be improved.

Although FIG. 8 illustrates embodiments in which the display device 10 includes the low refractive layer 400, the embodiments are not limited thereto. For example, the display device 10 may not include (e.g., omit) the low refractive layer 400 if the resonance effect of light emitted from the light-emitting elements ED is adequately or sufficiently secured by the multi-capping layer 300.

Referring to FIG. 10, the capping layer 300 may include the first capping layer 310, the second capping layer 320, and the third capping layer 330 as in some embodiments of FIG. 8, and may further include at least one of a fourth capping layer 340 disposed between the first capping layer 310 and the second capping layer 320, or a fifth capping layer 350 disposed between the third capping layer 330 and the first capping layer 310. In some embodiments, the capping layer 300 may include the third capping layer 330, the fifth capping layer 350, the first capping layer 310, the fourth capping layer 340, and the second capping layer 320 sequentially disposed on the second electrode 240 of the light-emitting elements ED. In some examples, the capping layer 300 may further include only one of the fourth capping layer 340 and the fifth capping layer 350, in addition to the first capping layer 310, the second capping layer 320, and the third capping layer 330. In another embodiment, the capping layer 300 may include only the first capping layer 310, the second capping layer 320, and the fourth capping layer 340, or may include only the first capping layer 310, the third capping layer 330, and the fifth capping layer 350.

In some embodiments, the refractive index may gradually decrease in the order of the first capping layer 310, the fourth capping layer 340, and the second capping layer 320. For example, the refractive index of the fourth capping layer 340 may be greater than or equal to the second refractive index of the second capping layer 320 and less than or equal to the first refractive index of the first capping layer 310. In some embodiments, the refractive index of the fourth capping layer 340 may have a value in the range of about 1.0 to about 3.0.

In some embodiments, the refractive index of the fourth capping layer 340 may gradually vary in a range from a minimum value greater than or equal to the second refractive index to a maximum value less than or equal to the first refractive index. For example, the refractive index of the fourth capping layer 340 may gradually decrease from a lower portion adjacent to the first capping layer 310 to an upper portion adjacent to the second capping layer 320. In some embodiments, the refractive index of the fourth capping layer 340 may gradually decrease as it approaches the second capping layer 320 in a range greater than or equal to the second refractive index and less than or equal to the first refractive index.

However, the embodiments are not limited thereto. For example, the refractive index of the fourth capping layer 340 may have a specific value between the second refractive index and the first refractive index.

In some embodiments, the refractive index may gradually increase in the order of the third capping layer 330, the fifth capping layer 350, and the first capping layer 310. For example, the refractive index of the fifth capping layer 350 may be greater than or equal to the refractive index of the third capping layer 330 and less than or equal to the first refractive index of the first capping layer 310. In some embodiments, the refractive index of the fifth capping layer 350 may have a value of about 1.0 to about 3.0.

In some embodiments, the refractive index of the fifth capping layer 350 may gradually vary in a range from a minimum value greater than or equal to the refractive index of the third capping layer 330 to a maximum value less than or equal to the first refractive index. For example, the refractive index of the fifth capping layer 350 may gradually increase from a lower portion adjacent to the third capping layer 330 to an upper portion adjacent to the first capping layer 310. In some embodiments, the refractive index of the fifth capping layer 350 may gradually increase as it approaches the first capping layer 310 in a range greater than or equal to the refractive index of the third capping layer 330 and less than or equal to the first refractive index.

However, the embodiments are not limited thereto. For example, the refractive index of the fifth capping layer 350 may have a specific value between the refractive index of the third capping layer 330 and the first refractive index.

In some embodiments, each of the fourth capping layer 340 and the fifth capping layer 350 may have a thickness ranging from approximately 5 nm (50 Å) to approximately 180 nm (1800 Å). The thickness of the fourth capping layer 340 and the thickness of the fifth capping layer 350 may be the same or different. In addition, the fourth capping layer 340 and the fifth capping layer 350 may contain the same material or different materials. The thickness and the refractive index range of each of the fourth capping layer 340 and the fifth capping layer 350 may be adjusted or optimized or substantially improved in consideration with the functions of each of the fourth capping layer 340 and the fifth capping layer 350 and the light efficiency of the pixels PX.

Even in the above-described embodiment, by disposing the multi-capping layer 300, including a plurality of films having different refractive indices, between the light-emitting elements ED and the encapsulation layer 500, the resonance of light emitted from the light-emitting elements ED may be appropriately controlled or enhanced. In addition, by gradually varying the refractive index in the capping layer 300, the interfacial reflection may be appropriately controlled or reduced. Accordingly, the light efficiency of the pixels PX and the display device 10 including them may be improved.

Although FIGS. 8, 9, and 10 illustrate embodiments in which the display device 10 includes the low refractive layer 400, the embodiments are not limited thereto. For example, the display device 10 may not include (e.g., omit) the low refractive layer 400 if the resonance effect of light emitted from the light-emitting elements ED is adequately or sufficiently secured by the multi-capping layer 300.

As described above, the display device 10 according to some embodiments includes the multi-capping layer 300 and the encapsulation layer 500 disposed on the second electrode 240 of the light-emitting elements ED. In some embodiments, the display device 10 may further include the low refractive layer 400 disposed between the multi-capping layer 300 and the encapsulation layer 500.

According to some embodiments, the resonance of light emitted from the light-emitting elements ED may be appropriately controlled or enhanced, and the interfacial reflection that may occur on the path along which the light is emitted may be reduced or weakened. As a result, the optical characteristics, including light efficiency, of the pixels PX may be improved, and the side viewing characteristics of the display device 10 may be improved.

It should be understood that embodiments described herein should be considered in a descriptive sense and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display device (10) comprising:
a substrate (100);
a light-emitting element (ED) on the substrate (100);
a multi-capping layer (300) comprising a first capping layer (310) on the light-emitting element (ED) and having a first refractive index, and a second capping layer (320) on the first capping layer (310) and having a second refractive index lower than the first refractive index;
a low refractive layer (400) on the multi-capping layer (300), and having a third refractive index lower than the second refractive index; and
a first encapsulation layer (510) on the low refractive layer (400), and comprising inorganic encapsulation layers (510A, 510B, 510C) having a refractive index higher than the third refractive index.

2. The display device (10) of claim 1, wherein the first refractive index has a value in a range of about 1.2 to about 3.0, and
wherein the second refractive index has a value in a range of about 1.0 to about 2.8; and/or
wherein a difference between the first refractive index and the second refractive index is about 0.2 or more; and/or
wherein a difference between the second refractive index and the third refractive index is about 0.2 or more.

3. The display device (10) of claim 1 or 2, wherein the first capping layer (310) has a thickness ranging from about 20 nm to about 140 nm; and/orwherein the second capping layer (320) has a thickness ranging from about 5 nm to about 100 nm; and/orwherein the low refractive layer (400) has a thickness ranging from about 20 nm to about 100 nm.

4. The display device (10) of at least one of claims 1 to 3, wherein the first encapsulation layer (510) comprises:
a first inorganic encapsulation layer (510A) on the low refractive layer (400), and having a fourth refractive index higher than the third refractive index;
a second inorganic encapsulation layer (510B) on the first inorganic encapsulation layer (510A), and having a fifth refractive index lower than the fourth refractive index; and
a third inorganic encapsulation layer (510C) on the second inorganic encapsulation layer (510B), and having a sixth refractive index lower than the fifth refractive index.

5. The display device (10) of claim 4, wherein the first inorganic encapsulation layer (510A) comprises silicon nitride, SiN_{X}.

6. The display device (10) of claim 4 or 5, wherein the second inorganic encapsulation layer (510B) and the third inorganic encapsulation layer (510C) contain silicon oxynitride ,SiON, and
wherein a content of nitrogen contained in the second inorganic encapsulation layer (510B) and a content of nitrogen contained in the third inorganic encapsulation layer (510C) are different from each other.

7. The display device (10) of at least one of claims 1 to 6, further comprising:
a second encapsulation layer (530) on the first encapsulation layer (510) and containing an organic material; and
a third encapsulation layer (540) on the second encapsulation layer (530) and containing an inorganic material.

8. The display device (10) of claim 7, further comprising:
a fourth encapsulation layer (520) between the first encapsulation layer (510) and the second encapsulation layer (530),
wherein the fourth encapsulation layer (520) comprises silicon oxynitride ,SiON, and
wherein a content of oxygen contained in the fourth encapsulation layer (520) is higher than a content of oxygen contained in the first encapsulation layer (510).

9. The display device (10) of at least one of claims 1 to 8, wherein the light-emitting element (ED) comprises:
a first electrode (220) on the substrate (100);
an intermediate layer (230) on the first electrode (220) and comprising a light-emitting layer (232, 234); and
a second electrode (240) on the intermediate layer (230).

10. The display device (10) of claim 9, wherein the first capping layer (310) is directly on the second electrode (240), and
wherein the second capping layer (320) is directly on the first capping layer (310).

11. The display device (10) of claim 9 or 10, wherein the low refractive layer (400) is directly on the second capping layer (320).

12. The display device (10) of claim 9, wherein the multi-capping layer (300) further comprises a third capping layer (330) between the second electrode (240) and the first capping layer (310) and having a refractive index lower than the first refractive index.

13. The display device (10) of claim 12, wherein the refractive index of the third capping layer (330) has a value in a range of about 1.0 to about 2.8; and/or
wherein a difference between the refractive index of the third capping layer (330) and the first refractive index is about 0.2 or more; and/or
wherein the third capping layer (330) has a thickness ranging from about 5 nm to about 100 nm.

14. The display device (10) of claim 12 or 13, wherein the multi-capping layer (300) further comprises at least one of:
a fourth capping (340) layer between the first capping layer (310) and the second capping layer (320), and having a refractive index that gradually decreases as it approaches the second capping layer (320) in a range greater than or equal to the second refractive index and less than or equal to the first refractive index; or
a fifth capping layer (350) between the third capping layer (330) and the first capping layer (310), and having a refractive index that gradually increases as it approaches the first capping layer (310) in a range greater than or equal to the refractive index of the third capping layer (330) and less than or equal to the first refractive index.

15. An electronic device for providing an image, comprising:
a display device (10) according to at least one of claims 1 to 14.
